# EUROPEAN PATENT SPECIFICATION

(11) **EP 3 714 203 B1**
(45) Date of publication and mention of the grant of the patent: **16.02.2022**
(21) Application number: 18830934.8
(22) Date of filing: 28.11.2018
(51) Int. Cl.: F21S 2/00, F21V 21/005, F21V 21/116, H05K 1/11, F21W 131/103, F21Y 105/16, F21Y 115/10, F21V 5/00, F21V 23/04, F21V 21/30

(54) **LIGHT ASSEMBLY MODULE AND LIGHT ASSEMBLY MODULE SYSTEM**
LICHTANORDNUNGSMODUL UND LICHTANORDNUNGSMODULSYSTEM
MODULE D'ENSEMBLE DE LUMIÈRE ET SYSTÈME DE MODULE D'ENSEMBLE DE LUMIÈRE

(30) Priority: 30.11.2017 IN 201721042918
(43) Date of publication of application: 30.09.2020
(73) Proprietor: Corvi Led Private Limited, Mumbai 400031 (IN)
(72) Inventor: SONI, Vimal J, Mumbai 400031 (IN)
(74) Representative: Angerhausen, Christoph
(86) International application number: PCT/IB2018/059381
(87) International publication number: WO 2019/106549

(56) References cited:
- EP-A1- 3 096 170
- WO-A1-2013/046339
- CN-A- 103 604 098
- CN-A- 105 222 057
- CN-U- 202 902 197
- US-A1- 2005 116 235
- US-A1- 2007 216 274
- US-A1- 2013 027 935
- US-A1- 2013 088 864
- US-A1- 2013 329 427

## Description

### FIELD OF THE INVENTION

The present invention relates to a light assembly module according to the preamble of claim 1, a corresponding multiple light assembly module set according to claim 11 and a light assembly module system according claim 12.

### BACKGROUND OF THE INVENTION

Lighting assemblies or luminaires are known for illuminating wide spaces both indoors and outdoors. The light sources of such luminaires include low to high pressure discharge lamps, HID-lamps (High Intensity Discharge lamp), incandescent bulbs, and LEDs (Light Emitting Diodes). To conserve energy for environ-mental and/or economic reasons, luminaires are retrofitted or replaced with luminaires having light sources requiring less energy, in particular fewer Watts per lumen. For the illumination of wide spaces, however, bright luminaires are preferred, if not required. For such luminaires in particular, thermal management means are provided to prevent overheating of structures surrounding the light source and/or to optimise operation of the light source in the ideal temperature range. Thermal management means for luminaires include heat sinks in thermal contact with the heat generating components of the luminaires that transfer heat away from luminaire via conduction or convection, in some cases by active (forced) convection. However, providing luminaires with dedicated heat sinks complicates their manufacture and increases their cost. Documents US 2013/027935A1, US 2013/088864A1, and CN 105222057A show modular lighting assemblies.

### SUMMARY OF THE INVENTION

An object underlying the present invention is to provide a light assembly for illuminating wide spaces which is economical in manufacture and efficient in use, and which in particular is easily installed.

In an aspect, the object is solved by a light assembly module according to claim 1. Such a geometry enables the fixture rims of multiple light assembly modules to be hooked into one another. The light assembly module has the advantage that it is easily scalable, meaning that it can be easily connected to at least one other light assembly module to increase the number of light sources for illuminating a wide space. The spacing between individual light sources of one light assembly module can be advantageously maintained when other light assembly modules are connected to it, thereby helping to maintain the ideal operating temperature for the most energy efficient light emission by the light sources.

In an embodiment, the projections of the fixture rim are shaped so as to mechanically engage with recesses of another light assembly module and/or mount. Similarly, in an embodiment, the recesses of the fixture rim are shaped so as to mechanically engage with projections of another light assembly module and / or mount.

In an embodiment, relative to the lateral extent of the base plate or relative to an axis normal to the base plate, the shape of the fixture rim in the first section is inverted with respect to the fixture rim in the second section.

Preferably, the first section of the fixture rim extends along half of the base plate outline. Similarly, the second section of the fixture rim preferably extends along the other half of the base plate outline. In an embodiment, a plurality of projections and recesses are distributed in lines along the first and second sections of the fixture rim, whereby each line of projections and recesses engages with a suitably arranged line of counterpart projections or recesses of the another light assembly module and / or mount.

According to the invention, the fixture rim comprises an outer wall and an inner wall, wherein the projections constitute a part of the outer wall and the recesses are located between the outer wall and the inner wall.

According to the invention, the outer wall of the fixture rim is notched and comprises a series of projections separated from one another by notches in the manner of a line of teeth. Preferably, the line of teeth is preferably shaped so as to engage with a suitably arranged line of counterpart recesses of the other light assembly module and / or mount.

In an embodiment of the light assembly module, the base plate comprises an outer face with a normal vector directed away from the illumination direction of the light sources and an inner face with a normal vector in the illumination direction of the light sources. Preferably, the inner and outer base plate faces are essentially planar. Preferably, the base plate surrounds a cavity bounded by the base plate's inner face and the inner side of the fixture rim's inner wall.

In an embodiment, a plurality of strengthening ribs are arranged on the outer face of the base plate. Preferably, the strengthening ribs have a first end at the fixture rim end and extend away from said first end to a second end on the outer face of the base plate. In embodiment, the strengthening ribs have a shape that tapers down to the second end. In a variation, the first ends of the strengthening ribs are taller than the average height of the fixture rim. In an embodiment, a single plastic piece constitutes the base plate. For example, the base plate may be injection moulded.

In an embodiment of the light assembly module, the outer face of the base plate comprises a bird protector including an array of thin rods arranged to prevent resting of birds on the base plate.

In an embodiment, the light assembly module includes an electronic circuit carrier, wherein a part of an electronic circuit is arranged on or integrated in the electronic circuit carrier, and wherein the light sources constitute components of the electronic circuit. The electronic circuit carrier is preferably at least partially arranged in the base plate, for example in the base plate's cavity. In particular, the electronic circuit carrier is for example a board, wherein the board may have an outline complementing and preferably at least partially abutting the inner side of the base plate's inner wall. For example, the electronic circuit carrier is a PCB that connects electronic components of the electronic circuit to each other via electrically conductive structures. The electrically conductive structures are preferably etched out of metal sheets arranged on a substrate of the electronic circuit carrier. In an embodiment, the light sources as components of the electronic circuit are arranged in a grid-like pattern on the electronic circuit carrier. Preferably, the electronic circuit carrier comprises a plurality of holes and the base plate comprises a plurality of pins projecting from its inner face in the direction of illumination, whereby the holes in the electronic circuit carrier and the pins are axially aligned such that they engage when the electronic circuit carrier is mounted on the base plate in a snap-on connection. The electronic circuit carrier is preferably arranged between the base plate and a cover assembly as described in this document. Preferably, a seal such as gasket is arranged between the electronic circuit carrier and the base plate.

In an embodiment, the light sources include LEDs. The LEDs may be directly mounted on a PCB and each contact anode and cathode conductors of the PCB. Preferably, the electronic circuit carrier contains material with a thermal conductivity sufficiently high to facilitate thermal management of heat generated by the electronic circuit and the light sources.

In an embodiment, the electronic circuit carrier comprises electrical conductors contacting the light sources via electrical contact pads, and further comprises first dielectric clearance gaps extending along the outer face of the electronic circuit carrier, the light sources bridging the first dielectric clearance gaps, wherein the electrical conductors are bounded on at least two sides by the dielectric clearance gaps. In addition, the electronic circuit carrier may comprise second dielectric clearance gaps extending along its outer face, wherein the electrical conductors are bounded on at least two other sides by the second dielectric clearance gaps. The electronic conductors preferably have a surface area maximised for heat spread and dissipation, thereby improving the efficiency of the light assembly module. The electrical conductors preferably take up at least one third, more preferably at least two thirds of the area between first and second dielectric clearance gaps. In an embodiment, additional electronic circuit components are mounted on the outer face of the electronic circuit carrier. Preferably, the second dielectric clearance gaps surround said additional components. In an embodiment, the first and second dielectric clearance gaps cross each other.

In an embodiment, the light assembly module includes a cover assembly comprising a base sheet that covers at least a part of the base plate, and, preferably, protects the interior of the light assembly module against environmental factors such as moisture and insects. In an embodiment, the cover assembly fits into the base sheet's cavity. In an embodiment, the base sheet is at least partly permeable to light, for example comprising a plurality optically refractive structures for directing the light emitted from the light sources in the desired manner. Preferably, the optically refractive structures are arranged in a grid-like pattern. They may be concave or convex and are preferably in axial alignment with the respective light sources arranged beneath them.

In an embodiment, the cover assembly comprises a plurality of recesses for receiving other components of the light assembly module.

In an embodiment, the cover assembly comprises an optical function sheet and a base sheet, the optical function sheet being attached to the base sheet, for example to its inner face. The optical function sheet is at least partly permeable to light and in an embodiment comprises a plurality of optically refractive areas in axial alignment with the respective light sources arranged beneath them, whereby the optically refractive areas are preferably arranged in a grid-like pattern.

In an embodiment, the base sheet comprises a plurality of recesses and the optical function sheet is attached to the base sheet in such as way that the optically refractive areas of the optical function sheet project through the recesses of the base sheet. For example, the optical function sheet may comprise a plurality of convex refractive areas, the vertices of which point away from the light sources.

In an embodiment, the optical function sheet comprises clips for a snap-on connection with the base sheet. For example, clips may be provided next to the optically refractive structures such that when the lens arrangement sheet is attached to the base sheet, the clips snap into the recesses of the base sheet.

In an embodiment of the cover assembly, the optical function sheet comprises a plurality of concave refractive areas the vertices of which point toward the light sources, whereby the base sheet to which the optical function sheet is attached may be continuously flat or may it comprise recesses.

In an embodiment, the light assembly module comprises a sensor assembly with at least one sensor adapted to sense environmental changes outside of the light assembly module. In an embodiment, the sensor assembly comprises a motion sensor for detecting the movement of an object in the vicinity of the light assembly module, preferably in the vicinity of the area illuminated by the light assembly module. Alternatively or in addition, the sensor assembly comprises an ambient sensor adapted to sense ambient light, in particular direct or scattered sunlight and/or the absence thereof. In an embodiment, the at least one sensor is electrically connected to the electronic circuit of the light assembly module, whereby, in an embodiment, the sensor assembly is arranged, in particular mounted on the electronic circuit carrier. In an embodiment, the sensor assembly project through is covered by a recess of the base sheet.

In an aspect, the object underlying the invention is also solved by a multiple light assembly module set comprising a plurality of light assembly modules, wherein the fixture rim of each light assembly module engages with the fixture rim of the at least one other light assembly module of the set.

In a further aspect, the object underlying the invention is solved by a light assembly module system including at least one light assembly module as described in this document and a mount for mounting it to an object, wherein the mount comprises a first structure shaped to mechanically engage the fixture rim of the at least one light assembly module and a second structure for fixing the mount to the object.

In an embodiment of the light assembly module system, the first structure of the mount comprises a clip element including an inner wall and an outer wall separated by at least one recess shaped so as to engage, for example clamp the fixture rim of the at least one light assembly module. For example, the outer wall of the clip element comprises at least one projection shaped so as to mechanically engage with a recess of the at least one light assembly module. Preferably, the clip element of the mount comprises a plurality of projections shaped so as to mechanically engage with recesses of a plurality of light assembly modules jointly. In an embodiment, the outer wall of the clip element is notched and preferably comprises a series of projections separated from one another by notches in the manner of a line of teeth. Preferably, the projections of the outer wall of the clip element are shaped so as to engage with counterpart recesses of the system's light assembly module. In particular, the line of teeth is preferably shaped so as to engage with a suitably arranged line of counterpart recesses of the system's light assembly module.

In an embodiment of the mount, the second structure is shaped to mechanically engage an intermediate connector which attaches to the object. The second structure for example comprises at least one surface with a recess to engage with the intermediate connector. The latter is preferably an element or its functional equivalent chosen out of the group: clamp, tie, plate, fastener comprising a surface resistive against removal of the mount from the object.

In an embodiment of the light assembly module system, it comprises at least one intermediate connector for connecting the second structure of the at least one mount to the object.

In an embodiment of the light assembly module system, it comprises a joint for moveably connecting the intermediate connector to the second structure of the mount. For example, the joint enables pivoting or tilting of the mount and at least one light assembly module attached thereto with respect to the object.

### BRIEF DESCRIPTION OF THE DRAWINGS

The herein described invention will be more fully understood from the detailed description given herein below and the accompanying drawings which should not be considered limiting to the invention described in the appended claims. Shown are:
- Fig 1:: a perspective view of a basic embodiment of a base plate of a light assembly module;
- Fig 2:: a perspective view of another basic embodiment view of a base plate a light assembly module,
- Fig 3:: an exploded view of light assembly module system with a bracket mount and a pole;
- Fig 4:: an exploded view of the arrangement of base plate, electronic circuit carrier, and cover assembly of the light assembly module according to Fig. 3;
- Fig 5:: a front view of the light assembly module system according to Fig. 3;
- Fig 6:: a top view of the light assembly module system according to Fig. 3;
- Fig 7:: a side view of the light assembly module system according to Fig. 3;
- Fig 8:: a view of cross-section A - A indicated in Fig. 7;
- Fig 9:: a bottom view of the light assembly module system according to Fig. 3;
- Fig 10:: a view of cross-section B - B indicated in Fig. 9;
- Fig 11:: a view of cross-section C - C indicated in Fig. 9;
- Fig 12:: an exploded view of a light assembly module system comprising two light assembly modules with a common mount;
- Fig 13:: a front view of the light assembly module system according to Fig. 12;
- Fig 14:: a top view of the light assembly module system according to Fig. 12;
- Fig 15:: a side view of the light assembly module system according to Fig. 12;
- Fig 16:: a view of cross-section A - A indicated in Fig. 15;
- Fig 17:: a bottom view of the light assembly module system according to Fig. 12;
- Fig 18:: a view of cross-section B - B indicated in Fig. 17;
- Fig 19:: a view of section C - C indicated in Fig. 17;
- Fig 20:: an exploded view of light assembly module system with two mounts suitable for mounting in a highbay or onto a ceiling;
- Fig 21:: an exploded view of the arrangement of base plate, electronic circuit carrier, and cover assembly of the light assembly module according to Fig. 20;
- Fig 22:: an exploded view of the arrangement of base plate, electronic circuit carrier, and cover assembly of the light assembly module according to Fig. 21 showing the opposite faces of these elements ;
- Fig 23:: a front view of the light assembly module system according to Fig. 21;
- Fig 24:: a top view of the light assembly module system according to Fig. 21;
- Fig 25:: a side view of the light assembly module system according to Fig. 21;
- Fig 26:: a view onto the illumination side of the light assembly module system according to Fig. 21;
- Fig 27:: a view of cross-section A - A indicated in Fig. 26;
- Fig 28:: a view of cross-section B - B indicated in Fig. 26;
- Fig 29:: a view of cross-section C - C indicated in Fig. 26;
- Fig 30:: an exploded view of a light assembly module system comprising multiple light assembly modules and multiple mounts;
- Fig 31:: a front view of the light assembly module system according to Fig. 30;
- Fig 32:: a top view of the light assembly module system according to Fig. 30;
- Fig 33:: a side view of the light assembly module system according to Fig. 30;
- Fig 34:: a view onto the illumination side of the light assembly module system according to Fig. 30;
- Fig 35:: a view of cross-section A - A indicated in Fig. 34;
- Fig 36:: a view of cross-section B - B indicated in Fig. 34;
- Fig 37:: a view of cross-section C - C indicated in Fig. 34;
- Fig 38:: a view of cross-section D - D indicated in Fig. 34
- Fig 39:: an exploded view of a light assembly module system comprising an alternative bracket mount and pole;
- Fig 40:: a front view of the light assembly module system according to Fig. 39;
- Fig 41:: a side view of the light assembly module system according to Fig. 39;
- Fig 42:: a top view of the light assembly module system according to Fig. 39;
- Fig 43:: another front view of the light assembly module system according to Fig. 39;
- Fig 44:: a view of cross-section A - A indicated in Fig. 43;
- Fig 45:: a view of cross-section B - B indicated in Fig. 43;
- Fig 46:: an exploded view of a light assembly module system comprising a mount attached to an intermediate connector via a pivot connection;
- Fig 47:: a top view of the light assembly module system according to Fig. 46;
- Fig 48:: a side view of the light assembly module system according to Fig. 46;
- Fig 49:: a view onto the illumination side of the light assembly module system according to Fig. 46;
- Fig 50:: another view onto the illumination side of the light assembly module system according to Fig. 46;
- Fig 51:: a view of cross-section A - A indicated in Fig. 50;
- Fig 52:: a view of cross-section B - B indicated in Fig. 50;
- Fig 53:: an exploded view of a sensor module assembly mounted on the electronic circuit carrier of a light assembly module;
- Fig 54:: a close-up perspective view of a part of the outer face of the electronic circuit carrier of a light assembly module;
- Fig 55:: a close-up perspective view of an LED mounted on the outer face of the electronic circuit carrier of a light assembly module;
- Fig 56:: a cross-section view of a part of the electronic circuit carrier of a light assembly module.

### DESCRIPTION OF THE EMBODIMENTS

Reference will now be made in detail to certain embodiments, examples of which are illustrated in the accompanying drawings, in which some, but not all features are shown. Whenever possible, like reference numbers will be used to refer to like components or parts.

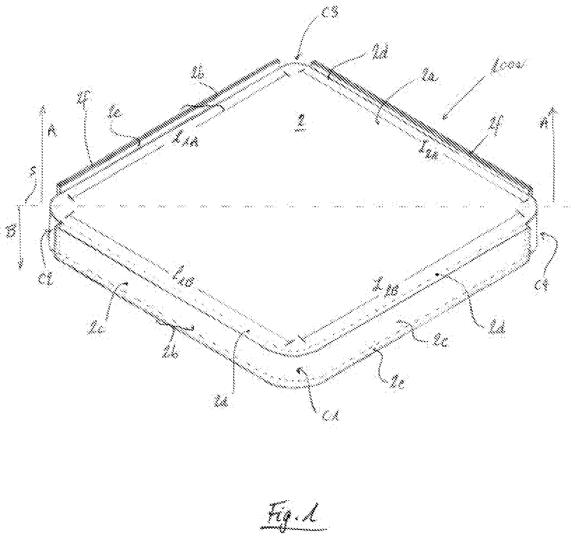

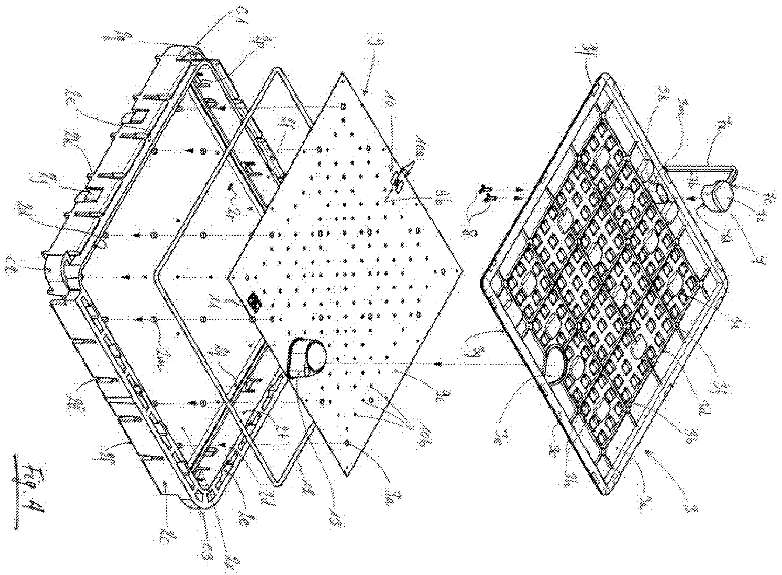

**Figure 1** shows an essentially rectangular base plate 2 of a light assembly module 100a according to the present invention comprising a fixture rim 9 with projections 2f along the sides L_{1A}, L_{2A}, L_{1B}, L_{2B} of the base plate 2 that constitute parts of its outer wall 2c. The base plate 2 comprises an outer face 2a having a surface normal directed away from the illumination direction of light sources (shown in Figure 4), the light sources being located on the opposite side (hidden from view) of the base plate's upper surface 8a. The base plate 2 is geometrically divided into two sectors A and B on either side of a line S connecting two corners C2 and C4 of the base plate 2. Sector A is a holding sector where the fixture rim 2b can hold another light assembly module or a mount while sector B is an insertion sector where the fixture rim 2b can be inserted into another light assembly module or mount. Holding sector A provides a force against gravity to hold the other light assembly module or mount while the insertion sector B exerts a force, in particular weight, onto a light assembly module or mount. The projections 2f in sector A project in a direction opposite the illumination direction of the light sources. The projections 2f in sector B (hidden from view) project in the opposite direction, i.e. in the direction of illumination of the light sources. The projections 2f are shaped as folded flanges of the base plate 2 and in sector A, they extend from the inner wall 2d on the illumination side of the base plate 2 and fold back towards the opposite or surface 8a side of the base plate 2. In section B, the projections 2f are also shaped as folded flanges that extend from the surface 8a of the base plate 2 and fold back towards the illumination side of the base plate 2.

The base plate 2 further comprises an inner wall 2d extending along the sides L_{1A}, L_{2A}, L_{1B}, L_{2B} that is essentially equidistant to the outer wall 2c and is separated from the latter by recesses 2e. In corner regions C1, C2, C3 and C4 of the base plate 2, the outer wall 2c merges into the inner wall 2d, i.e. the outline and hence the outer wall of the base plate in said corner regions is constituted by the inner wall 2d of the base plate. Although a rectangular base plate 2 is shown, it may alternatively comprise three or more sides. For example, it may be hexagonal, whereby each side comprises an inner and outer wall as described. The base plate 2 may contain a plastic as its primary constituent material. In an embodiment, it is injection moulded.

Via its fixture rim 2b, the light assembly module 100a can be hooked into a fixture, in particular into a similarly designed fixture rim of another light assembly module or mount comprising a recess into which the projections 2f of the outer wall can be inserted. In addition or alternatively, the light assembly module 100a can be hooked into a fixture, in particular into a similarly designed fixture rim of another light assembly module or mount comprising a projection over which the recess 9c of the fixture rim 2b can be slipped. In this way, the light assembly module 110a can be connected to other light assembly modules to provide a light assembly module set, and, if the light assembly module is attached to a mount, a light assembly module system is provided.

The base plate 2 can be provided with additional features described in more detail with respect to other embodiments.

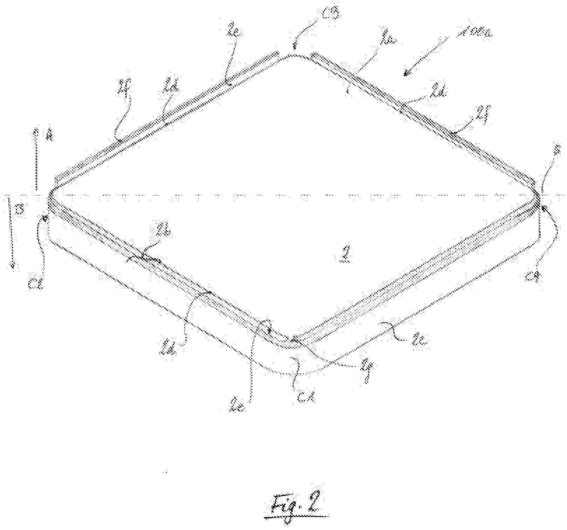

**Figure** 2 shows a variant of the embodiment according to Figure 1, wherein the recesses 2e of the fixture rim 2b are accessible from both sides of the fixture rim 2b, i.e. the recesses 2e have openings on both on the illumination side and on the opposite side of the base plate 2. The outer wall 2c of the fixture rim 2b is attached to the inner wall 2d along the sides of the base plate 2 via bridges 2g, one of which is visible in the drawing in section B while the other is hidden underneath the fixture rim 2b in section A (on the illumination side) of the base plate 2. Providing a fixture rim 2b with recesses 2e with openings on both sides of the base plate 2 has the advantage that projections of any height of another light assembly can be inserted through them while the plane of the base plate of said another light assembly module can rest essentially flush with the plane of the light assembly module to which it is attached.

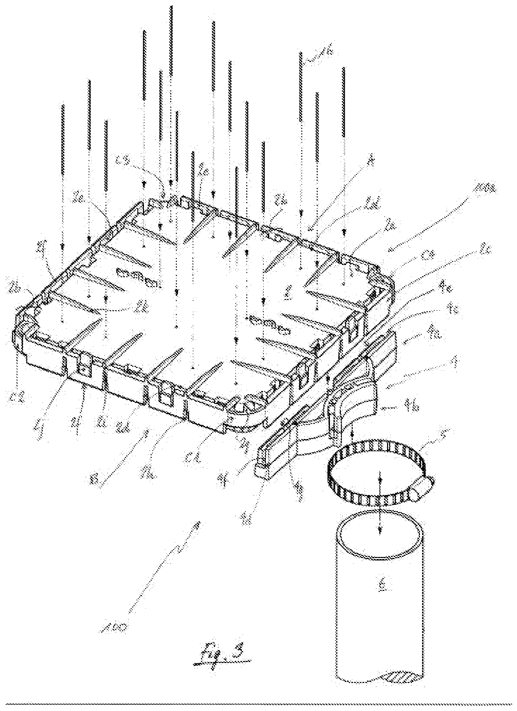

**Figure 3** is an exploded view of a light assembly module system 100 in which an essentially rectangular base plate 2 of a light assembly module 100a, a mount 4, an intermediate connector 5 and an object 6, for example a pole or a pipe to which the light assembly module 100a can be attached, are shown. On the inside of the base plate 2 hidden from view in this perspective are light sources. Also shown is a bird protector 16 consisting of an array of spikes or rods inserted into the outer face 2a of the base plate 2 that is directed away from light sources. The outer face 2a of the base plate 2 is essentially planar. The edge of the base plate 2 comprises a fixture rim 2b, including a series of interconnected projections 2f that for the most part constitute the outer wall 2c of the base plate 2, wherein each projection 2f is separated from a neighbouring projection by a notch 2h.

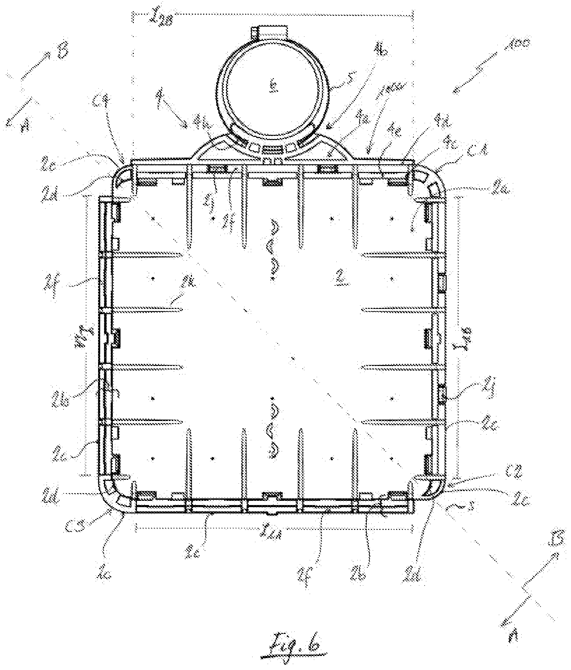

The projections 2f and notches 2h of the outer wall 2c of the fixture rim 2b can be understood as a line of teeth. As explained with reference to Figure 1, the fixture rim 2b is divided into two sectors A and B (shown in additional detail in Figure 6).

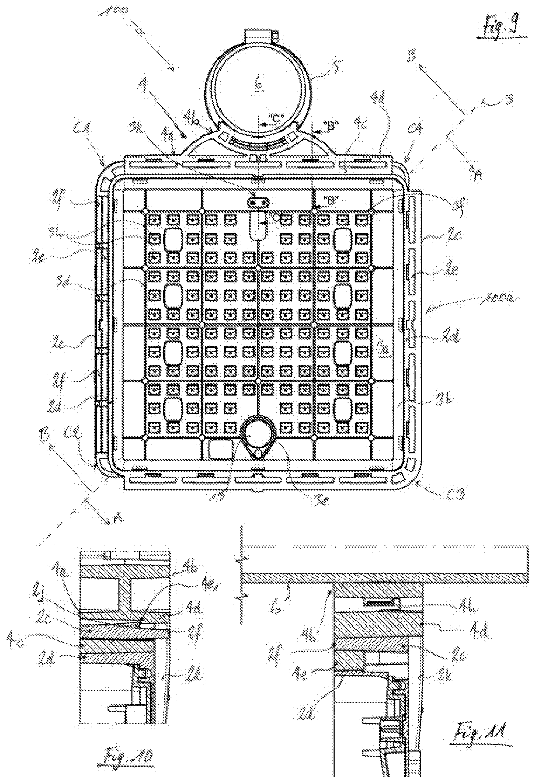

In sector A, the front (bite) end of the line of teeth or projections 2f is directed opposite the illumination direction of the light sources. In sector B, the front (bite) end of the corresponding line of teeth or projections 2f points in the illumination direction of the light sources. The lines of teeth in sections A and B can therefore be said to be inverted relative to one another or point in opposite directions. Figure 3 also shows corner regions C1, C2 and C4 of the base plate 2 which are explained in greater detail with reference to Figures 6 and 9. The outer wall 2c is separated in sections from the outer face 2a of the base plate 2 and from the inner wall 2d (see also Figure 4) of the fixture rim 2b by recesses 2e. The outer wall 2c is connected in sections to the outer face 2a of the base plate 2 and to the inner wall 2d by strengthening ribs 2k. Insofar as they bridge the recesses 2e, the strengthening ribs 2k also have the function of bridges 2g shown in Figure 2.

A first set of strengthening ribs 2k is arranged on the base plate outer face 2a and these strengthening ribs extend away from the front (bite) end of the line of teeth or projections 2f in section A of the fixture rim 2b toward the centre of the outer face 2a and taper down along the way. The strengthening ribs of another set extend away from the back (base) end of the line of teeth or projections 2f in section B of the fixture rim 2b and taper down along the way. The strengthening ribs of each section A and B partially traverse the outer face 2a of base plate 2.

The strengthening ribs 2k bridge recesses 2e between the inner and outer walls 2d, 2c of the fixture rim 2b. The ends of the strengthening ribs 2k at the fixture rim 2b are preferably flush with the outer surface outer wall 2c of the base plate 2.

The ends of the strengthening ribs 2k at outer wall 2c of the base plate 2 add to the height of the former. Separating the end of the strengthening ribs 2k at the outer wall 2c from a notch 2h between two neighbouring projections are bridge section 2i of the outer wall 2c.

Some of the projections 2f in section B include embedded clips 2j preferably integral to the outer wall 2c of the base plate 2 for engagement with corresponding recesses of another light assembly module or mount 4. The clips 2j for example are rectangular with a longer side extending along the projection direction of the projection 2f and may comprise a stepped rectangular outer surface divided into two parts. Preferably, the surface normals of these two outer surface parts point outward from the fixture rim 2b.

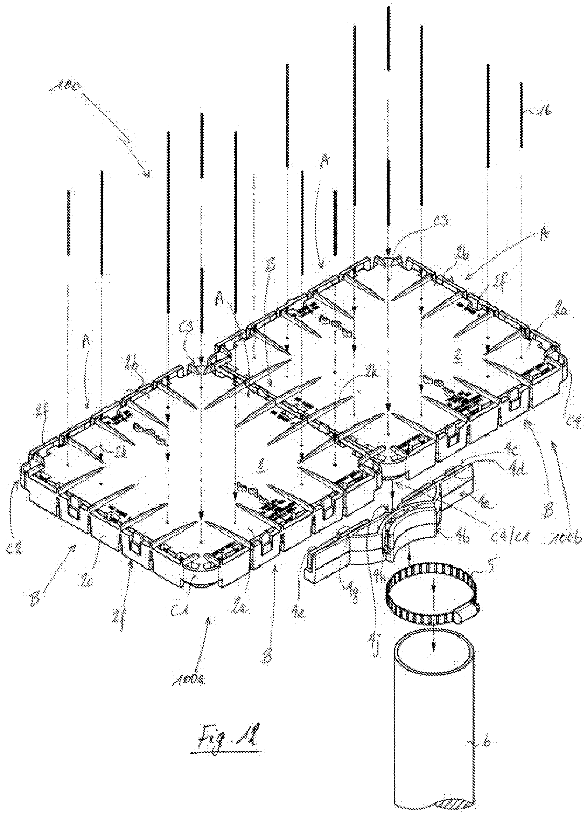

The front (bite) end of each line of teeth of sections A or B engages a corresponding structure of a mount 4 or of another light assembly module, whereby said front (bite) end of each line of teeth in particular is inserted into a corresponding recess 4f of the mount 4 or the another light assembly module (see Figure 12, for example).

The bracket mount 4 comprises, as part of a clip element, a first structure 4a including an outer wall 4c on the base plate side having a plurality of projections 4e separated from one another by notches 4g in the manner of a line of teeth and, on the object 6 side, an inner wall 4d. The mount 4 further comprises a second structure 4b adapted to fix the mount 4 to the object 6. The second structure 4b comprises a surface which faces and / or attaches to the object 6. For example, as shown here, second structure 4b is shaped to match the surface of the object 6 for a positive fit, in particular it comprises a concave surface with a radius of curvature matching the curvature of the object 6. In an advantageous embodiment of the mount 4, the second structure 4b comprises a recess (see Figure 6 for a cross-section view of recess 4h) into which an intermediate connector 5 can be inserted. The intermediate connector 5 may be embodied as a hose clamp insertable edge-on into the recess of the second structure 4b. When the intermediate connector 5 is fixed to the object 6 and tightened, the mount 4 is forced onto the object 6 in a tight clamping fit by which the light assembly module 100a is fixedly attached to the object 6 and immobilised against vertical or lateral displacement.

**Figure 4** shows parts of a light assembly module 1 as seen from the illumination side. The outer face 3a of a cover assembly 3, the illumination face 9c of a electronic circuit carrier 9, a gasket 12 and inner surfaces 2s and 2t of the base plate 2 are shown. Also shown are the fixture rim 2b of the base plate including an outer wall 2c formed by a line of projections 2f separated from one another by notches 2h. The fixture rim 2b also includes an inner wall 2d, whereby recesses, grooves or slots 2e are formed between the inner wall 2d and the outer wall 2c. A cavity is bounded by the base plate 2, in particular by the inner surface 2t of its inner wall 2d, the inner face 2s on the reverse side of outer face 2a, wherein the inner face 2s of the base plate 2 has a surface normal opposite that of the outer surface 2a. The inner face 2s of the base plate comprises a plurality of pins 2m, preferably arranged in a regular, for example grid-like pattern.

The light sources 10b are mounted on the illumination face 9c of the electronic circuit carrier 9. The light sources 10b for example are LEDs and the electronic circuit carrier 9 may be a PCB, of which an i/o terminal 10a of the electronic circuit 10 is shown to and from which conductive structures (not shown) lead and electrically connect the LEDs. The PCB 9 contains an FR4 material and the electrically conductive structures of the electronic circuit 10 preferably contain copper. The PCB 9 comprises an outline for a snug fit into the cavity surrounded by the inner surfaces of the base plate 2. For this purpose, the electronic circuit carrier 9 may be rectangular of which each side has a length essentially the same as the length of a corresponding inner side 2t of the inner wall 2d of fixture rim 2b. In particular, the PCB 9 comprises a plurality of holes 9a positioned to be aligned with the pins 2m on the inner face 2s of the base plate. When the PCB 9 is set into the cavity and mounted on the inner surface 2s of the base plate 2, the pins 2m project through the holes 9a of the PCB 9, thereby laterally stablising the PCB 9 on the inner face 2s of the base plate. To electrically connect the cable assembly 7 described below in additional detail, intermediate connectors 8 in the form of electrically conductive pins may be advantageously provided, whereby ends of the pins on the electronic circuit side are preferably flared for a high surface area connection to the i/o terminals 10a of the electronic circuit 10. In this respect, it is also preferred that the i/o terminals 10a of the electronic circuit 10 are rectangular, for example in the form of short electrically conductive strips. Further, the electronic circuit carrier 9 comprises an oblong recess 9b which fits tightly over a corresponding oblong projection 2r arranged on the inner face 2s of the base plate for lateral stabilisation of the electronic circuit carrier 9 and to help prevent short-circuiting between the contact pins 8 of the cable assembly. For this purpose, the oblong projection 2r preferably contains a material with a high dielectric constant which may be a material contained in the base plate or it may be another material.

In an advantageous embodiment, a Bluetooth module 11 is mounted on the electronic circuit carrier 9. The Bluetooth module 11 comprises a receiver for receiving Bluetooth signals from a wireless mobile device of a user of the light assembly module. The Bluetooth signals may contain requests for dimming and / or colour selection and are forwarded to a controller (not shown) connected to the electronic circuit 9 for controlling the light sources 10b. The transmitter of the Bluetooth module 11 may transmit Bluetooth signals to a wireless mobile device of a user to indicate the status of the light assembly module, for example the intensity and / or colour of the light emitted by the light assembly module. The Bluetooth module 11 may also be connected to the motion / and or ambient sensor assembly described below and transmit information to said user on detections made by the sensor.

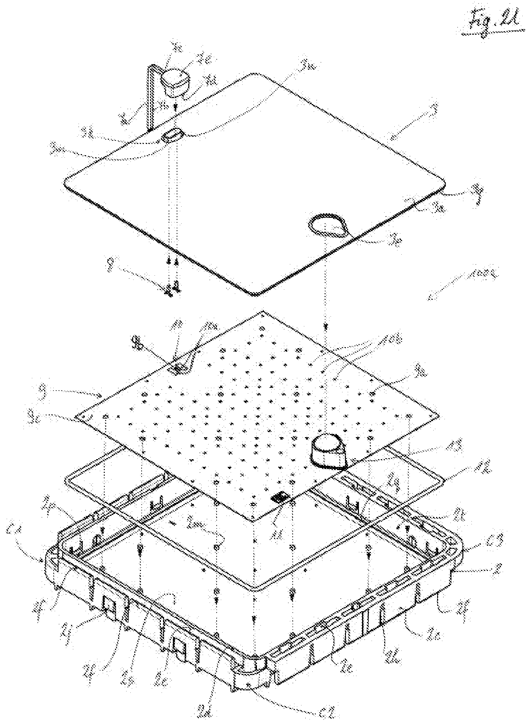

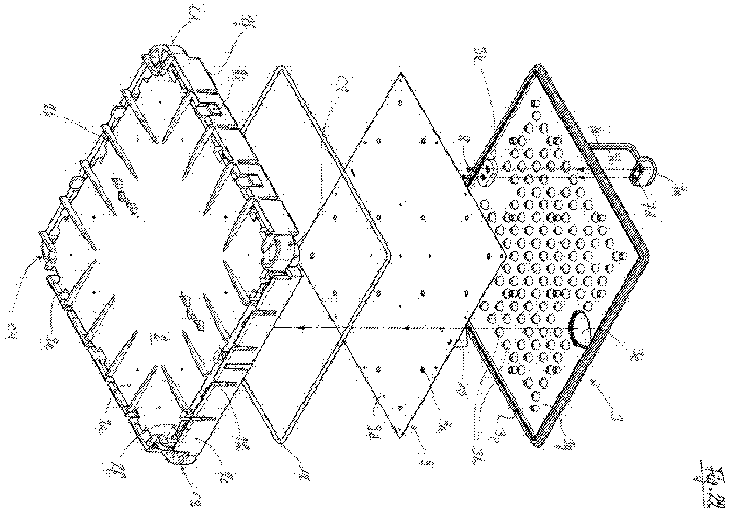

Still referring to **Figure 4**, the electronic circuit carrier 9, in particular the illumination face 9c of the electronic circuit carrier 9 is partly covered by a cover assembly 3 comprising a base sheet 3a, preferably consisting of one plastic piece, and in this embodiment comprising a regular pattern, in particular a grid pattern of recesses 3b into which convex optically refractive structures 3h of an underlying optical function sheet 3g (hidden in this view but shown in further detail in figures 21 and 22) of the cover assembly can be inserted, for example via a snap or clip connection. The edge of the base sheet 3a comprises a beaded rim 3c suitably designed for a snug fit of the cover assembly 3 into the cavity of the base plate 2. The cover assembly 3 may have a rectangular outline, whereby each side of the cover assembly has a length essentially the same as the length of a corresponding inner side 2t of the inner wall 2d of fixture rim 2b. The cover assembly 3 further comprises strengthening ribs 3d extending across the outer face of base sheet 3a between the recesses 3b so as not to obstruct the light passing through the optically refractive structures 3h of the optical function sheet 3g. The ends of the strengthening ribs 3d preferably abut the beaded rim 3c. Further, the outer edge of the beaded rim 3c comprises recesses 3f for engagement with clips 2p arranged on the inner surface 2t of the inner wall 2d of the base plate's fixture rim 2b. As the cover assembly 3 is installed in the cavity of the base plate, its edge pushes past the clips 2p, thereby sandwiching the electronic circuit carrier 9 and the gasket 12 between itself and the inner face 2s of the base plate. The clips 2p hinder vertical displacement of the cover assembly 3.

The cover assembly 3 also includes a port 3k for connection with a cable assembly 7 to electrically connect the electronic circuit 10. The port 3k preferably comprises a walled opening 3m projecting from the outer face of the base sheet 3a. The port 3k is preferably axially aligned with the i/o terminal 10a of the electronic circuit 10. The port also includes a recess in the optical function sheet 3g (hidden in this view but shown in further detail in figures 21 and 22) aligned to the walled opening 3m so that cable ends 7a, 7b can be passed through to the i/o terminal 10a.

As to the cable assembly 7 itself, it comprises insulated input and output cables 7a and 7b and a cable assembly termination cover 7e covering the ends of said cables at the light assembly module side. The cable assembly termination cover 7e comprises a cable input opening 7c into which the light assembly side ends of the cables 7a and 7b can be inserted. It further comprises a connector opening 7d which tightly fits around the port 3k when the cable assembly termination cover 7e is connected to the port 3k. The cable assembly termination cover 7e can be understood as a cap having the above described cable input opening 7c and the connector opening 7d. Preferably, the port 3k is arranged at or near the edge of the base sheet 3a so that it can be easily connected to the cable assembly 7 from one side with minimal traversing length of the cables across the outer face of the cover assembly.

Further, the inner face of the base sheet 3a or, alternatively, of the optical function sheet 3g, comprises a fixture rim comprising an inner wall and an outer wall with a recess arranged therebetween, wherein the inner and outer walls project against the direction of illumination, have a common centroid and are thus arranged equidistant from one another. An embodiment of such a fixture rim is shown in Figure 22 in additional detail. The fixture rim on the inner face of the base sheet 3a or optical function sheet 3g clamps around a ridge 2q arranged on the inner face 2s of the base plate 2 alongside the inner wall 2d to further stabilise lateral placement of the cover assembly 3 in the cavity of the base plate.

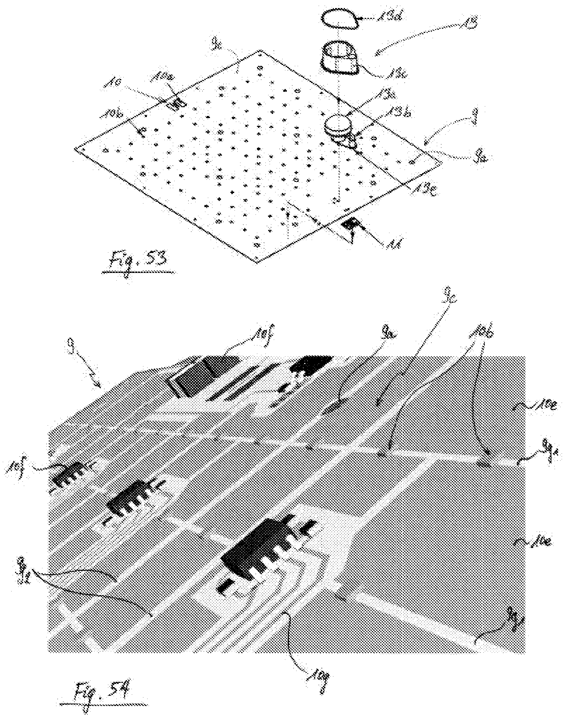

An advantageous embodiment of the light assembly module 1 includes a motion and / or ambient sensor assembly 13 which is mounted on the electronic circuit carrier 9, comprises a motion and / or ambient sensor (hidden from view in this figure) and is connected to the electronic circuit 10. In this case, the electronic circuit 10 is configured to respond to signals output from the motion and / or ambient sensor by switching the light sources 10b on or off, in particular via a controller (not shown) connected to the electronic circuit 10. The base sheet 3a and / or optical function sheet 3g of the cover assembly 3 preferably comprises a recess 3j with a shape corresponding to the contour of the motion and / or ambient sensor assembly 13. When the cover assembly 3 is installed in the cavity of the base plate 2, the motion and / or ambient sensor assembly 13 will project through the recess 3j of the cover assembly and be exposed to the outside. Instead of a recess 3j, however, the base sheet 3a and / or optical function sheet 3g of the cover assembly 3 may comprise an area with a raised topology to accommodate the motion and / or ambient sensor assembly 13 underneath it. Preferably, this raised part has a shape complementing the contours and topology of the motion and / or ambient sensor assembly. For example, the raised part can be shaped as a dome, hemispherical dome or as a plurality of co-joined domes or hemispherical domes. In the case of co-joined domes, these may have different dimensions such as differing radii of curvature and / or heights. Additional details relating to the motion and ambient sensor assembly 13 are given in the description of Figure 54.

In an preferred embodiment, a gasket 12 helps seal the interior of the light assembly module 100a and is arranged between the inner surface 2s of the base plate 2 and the electronic circuit carrier 9, whereby the gasket 12 abuts the inner surface 2t of the inner wall 2d of the fixture rim 2b and the electronic circuit carrier 9 rests on the gasket when installed in the cavity of the base plate.

It is to understood that the cover assembly 3 shown in Figure 4 is one possible embodiment, and that other cover assemblies such as those shown in Figures 21 and 22 can be used here instead.

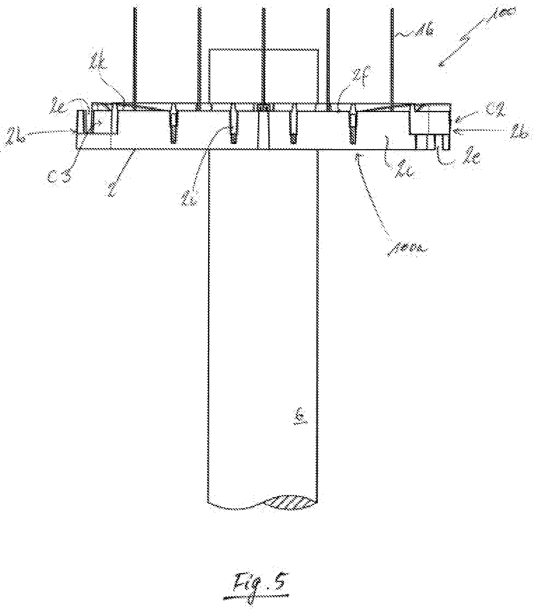

**Figure 5** is a front edge-on view of the light assembly module system 100 showing the opposite orientations and inverted relationship of the fixture rims 2b in sections A and B of base plate 2.

**Figure 6** is a top or bird's-eye view of the light assembly module system 100 wherein the light assembly module 100a is mounted on a pole 6. The base plate 2 is divided into two sectors A and B either side of a bisecting line S. The projections 2f of the fixture rim 2b in sector B are inserters for insertion into corresponding recesses of a mount 4 or another light assembly module. In sector A, the projections 2f are holding projections whereby the recess or recesses neighbouring these projections 2f receive corresponding projections of another light assembly module or mount. This perspective shows the intermediate connector 5 in the form of a hose clamp wrapped around the pole 6 and engaging the mount 4, in particular its second structure 4b. Projections 4e of the outer wall 4c of the mount 4 are shown in a state inserted into the corresponding recess 2e (see also Figure 4) of the base plate's rim fixture 2b along with the projections 2f and clips 2j along the outer wall 2c of the base plate's rim fixture 2b inserted into corresponding slots or recesses 4f (see also Figure 4) of the mount 4. The sides of the base plate 2 are designated as L_{1A}, L_{2A}, L_{1B} and L_{2B}. First side L_{1A} in sector A is connected to second side L_{2A} in sector A via corner region C3. Second side L2_{A} in sector A is connected to second side L_{2B} in sector B via corner region C4. Second side L_{2B} in sector B is connected to first side L_{1B} in sector B via corner region C1. Finally, first side L_{1B} in sector B is connected to first side L_{1A} in sector A via corner region C2.

On the outer side of the base plate 2, the fixture rim 2b transitions from a first geometry to a second geometry between sectors A and B. In corner region C2, the outer wall 2c and the inner wall 2d in sector B converge into the inner wall 2d of sector A. In corner region C4, the inner wall 2d forks out into an outer wall 2c and an inner wall 2d as it progresses from sector A to sector B. In corner region C3 of sector A and corner region C1 of sector B, the outer wall 2c of the fixture rim 2b is interrupted. On the illumination side of base plate 2, however, inner and outer walls 2d and 2c maintain the same distance to one another in these corner regions C3 and C1. The curved section of the light assembly module's corner regions C3 and C1 in this figure therefore corresponds to the outline of the outer wall 2c on the reverse side, i.e. the illumination side of the light assembly module 100a.

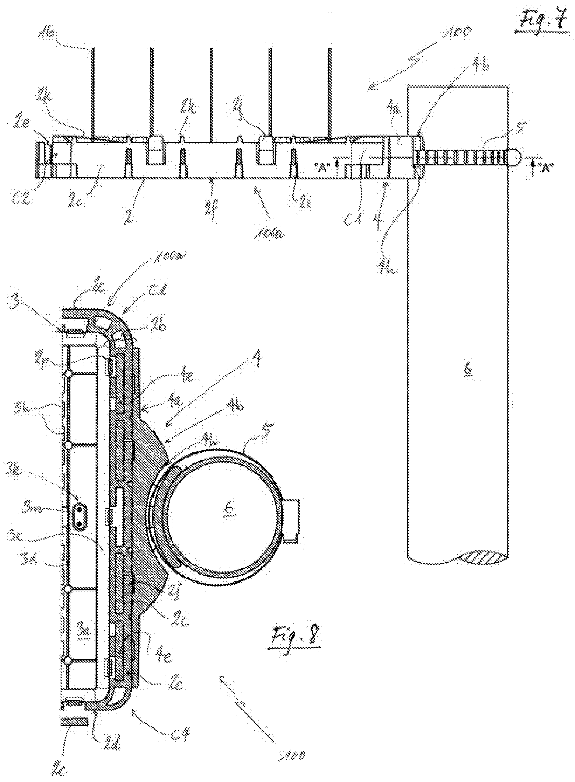

**Figure 7** is a side view of the light assembly module system 100 showing the engagement of intermediate connector or hose clamp 5 with a corresponding slot, recess or groove 4h in second structure 4b mount 4. This side view indicates a cross-section A-A shown in Figure 8.

Cross-section A-A, viewed from the illumination side of the light assembly module system 100, is shown in **Figure 8** and depicts the slit or groove 4h in the second structure 4b of mount 4 into which the hose clamp 5 can be inserted edge-on and through which it extends laterally. The slit 4h is curved to match the curved outer surface of a pipe or pole 6 on which the light assembly module 100a is mounted. Also shown are cross-sections on the same level of the fixture rim 2b, the cover assembly 3 and the port 3k with walled opening 3m. Corner region C4 is shown where inner and outer wall 2c and 2d of fixture rim 2b converge between sections A and B of the base plate 2. Corner region C1 is shown where outer and inner walls 2d and 2c are equidistant to each another. Further, a cross-section of projections 4e of outer wall 4c in the first structure 4a of the mount 4 are shown, wherein the (bite) line of teeth corresponding to the series of projections 4e is directed opposite the direction of illumination of the light sources. Conversely, the projections 2f of the outer wall 2c on this side L_{2B} (see Figure 4) in sector B of the base plate 2 point in the direction of illumination but this cross-section shows only their continuous base line into which the notches 2h (see Figure 1) do not or only slightly reach. Also shown are cross-sections of the clips 2p holding cover assembly 3.

**Figure 9** is a view onto the illumination side of a light assembly module system 100 showing details of the illumination side of base sheet 3a of cover assembly 3. As visible in cross-section B-B shown in **Figure 10**, in an embodiment of the mount 4, the inner wall 4d of first structure 4a of the mount 4 comprises a seat 4i that faces in the direction of illumination. Projection 2f of the outer wall 2c of fixture rim 2b of base plate 2 comprises a notch 2j which slides past the seat 4i when the fixture rim 2b of the light assembly module is interlocked with the mount 4. The perspective also permits a view onto the projection 2f of the outer wall 2c of the base plate 2 inserted between the inner wall 4d of first structure 4a of the mount 4 and projection 4e of the outer wall 4c that projects in the opposite direction as the projection 2f of the base plate 2. The projection 4e of the mount 4 in turn is shown in a state inserted between the inner wall 2d of the fixture rim 2b of the base plate and the projection 2f of the outer wall 2c of the base plate.

Cross section C-C shown in **Figure 11** shows the light assembly module 100a attached to pipe or pole 6 by means of mount 4 and intermediate connector 5, wherein the outer surface of the second structure 4b of the mount 4 form-fittingly meets the outer surface of the pipe or pole 6 and wherein the intermediate connector or hose clamp 5 is passed through a suitable slit 4h in the second structure 4b. A cross section of a projection 2f of the fixture rim's outer wall 2c is shown inserted into a corresponding recess or groove 4f between inner wall 4d and outer wall 4c of mount 4. Inserted between the inner wall 2d and the projection 2f of the outer wall 2c of the fixture rim 2b is a projection 4e of the mount 4 of lesser height located in the middle of the outer wall 4c of the mount 4. Both Figure 10 and Figure 11 show the tapering form of the strengthening rib 2k on the outer face 2a of the base plate 2 and how it bridges its inner and outer walls 2d and 2c.

**Figure 12** is an exploded view of a light assembly module system 100 comprising two light assembly modules 100a and 100b connected to each other by interlocking fixture rims 2b, in particular by interlocking of the recesses 2e of section A of fixture rim 2b of first single light assembly module 100a and with the projections 2f of complementary section B of fixture rim 2b of second single light assembly module 100b. A bracket mount 4 corresponding to mounts shown in the previous figures is shown. The central region 4j of the outer wall 4c of the mount 4 facing the base plates 2 of the single light assemblies 100a and 100b comprises a projection (not shown) of lesser height in order to account for and accommodate the corner regions C4 / C1 of the joined together light assembly modules. Taller projections 4e on either side of the central region 4j are inserted into the respective recesses 2e of the fixture rims 2b of both light assembly modules 100a and 100b. Figure 12 also shows the fixture rim ends of the strengthening ribs 2k of first light assembly module 100a abutting the corresponding end of the strengthening ribs 2k of second light assembly module 100b, thereby impeding an angular geometrical relationship between the outer faces 2a of the base plates 2, i.e. facilitating the outer faces 2a of the two light assembly modules 100a and 100b to be in one plane. The fixture rims 2b, outer faces 2a including the strengthening ribs 2k of the two light assembly modules 100a and 100b are the same to facilitate mechanical interconnection, however the interior of each light assembly module including the electronic circuit, light sources and cover assembly may be different.

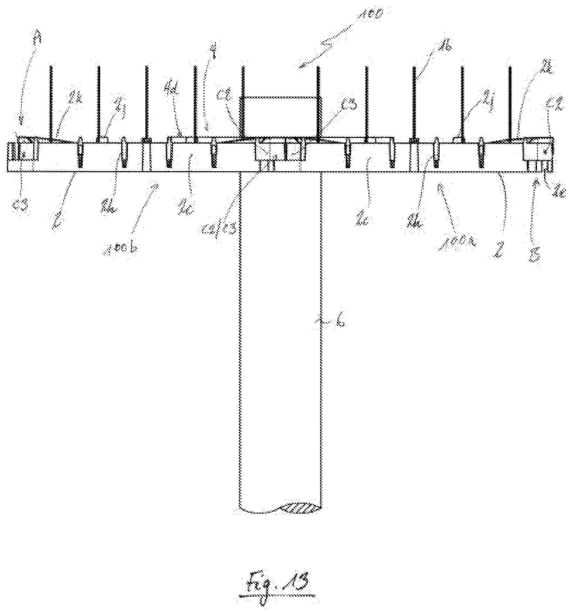

**Figure 13** corresponds to Figure 5 in that it is a front edge-on view onto each light assembly module 100a and 100b. In addition, Figure 13 also shows the corner overlap region C2 / C3 where the corners C2 and C3 of the light assembly modules 100a and 100b neighbour each other. The inverted relationship between the recesses 2e of the fixture rim 2b in sector A of second light assembly module 100b and the recesses 2e of the fixture rim 2b in sector B of first light assembly module 100a is maintained despite the light assembly being a scaled up with respect to the single light assembly module 1 shown in Figures 1 to 11. This demonstrates that further additional light assembly modules can be attached to the present light assembly module system 100, thereby scaling it up further still.

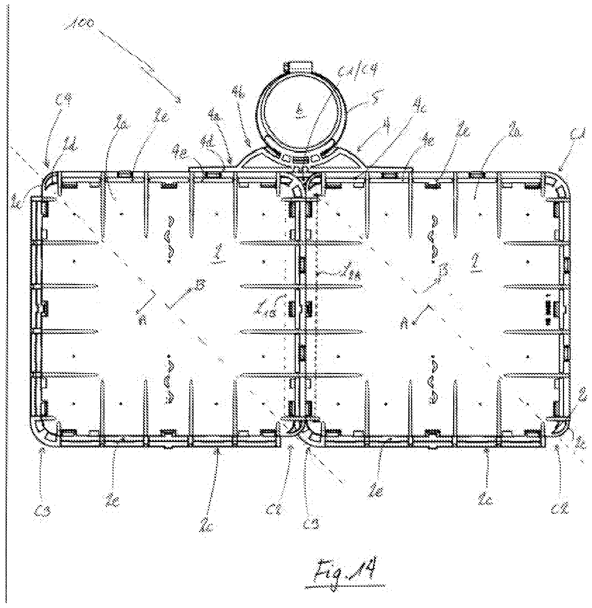

**Figure 14** is a top view onto the light assembly module system 100 comprising two light assembly modules 100a and 100b. In addition to the features shown in Figure 6, the present top view shows section A of first light assembly module 100a interconnected with section B of second light assembly module 100b. The mount 4 jointly holds both light assembly modules in that the projections 4e of the mount in a first section of the mount's outer wall 4c of first light assembly module 100a engage with corresponding recesses 2e of the fixture rim 2b of the first light assembly module 100a and projections 4e in a second section of the outer wall 4c engage with corresponding recesses 2e of the fixture rim 2b of the second light assembly module 100b. Second light assembly module 100b is hooked with its side L_{1B} of its section B into side L_{2A} of section A of the first light assembly 100a. Another feature shown is the corner overlap region C1 / C4 on the mount side of the light assembly module system 100 where the outer wall 2c of each light assembly module's fixture rim 2b in particular on their illumination sides (hidden in this view) is interrupted to facilitate engagement of the light assembly module system 100 with the mount 4 (see also overlap region C4 / C1 of Figure 12).

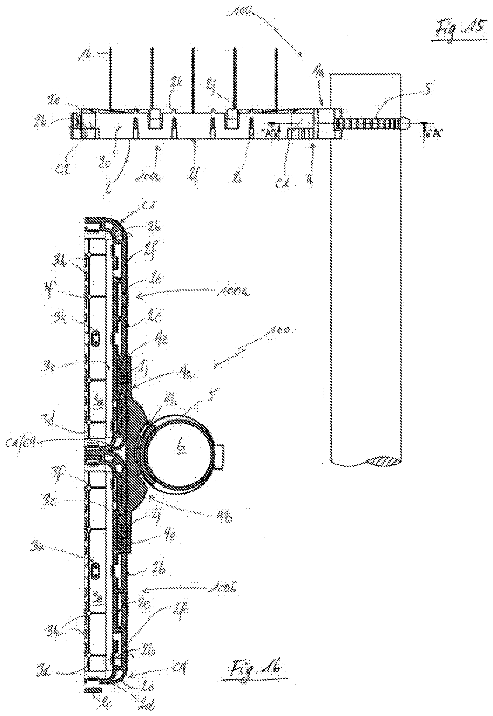

**Figure 15** is a side view onto the light assembly module system 100 showing the edge of light assembly module 100a with features corresponding to those shown in Figure 7.

**Figure 16** shows cross-section A-A indicated in Figure 15 revealing cross-section parts of light assembly modules 100a and 100b with features corresponding to those shown in Figure 8. In addition, corner overlap region C1 / C4 is shown where the outer wall 2c of fixture rim 2b of first light assembly module 100a bends away from the outer wall 2c of fixture rim 2b of neighbouring second light assembly 100b. The mount 4 holds the light assembly module system 100 with projections 4e on either side of this fixture rim overlap region inserted into recesses 2e of the fixture rim 2b of each light assembly module. Accounting for the diverging geometries of the fixture rims 2b of neighbouring light assembly modules where suitable recesses 2e for engagement with projections 4e are absent, the central region 4j (see Figure 12) of the mount's base first structure 4a facing the light assembly modules comprises a gap free or mostly free of projections.

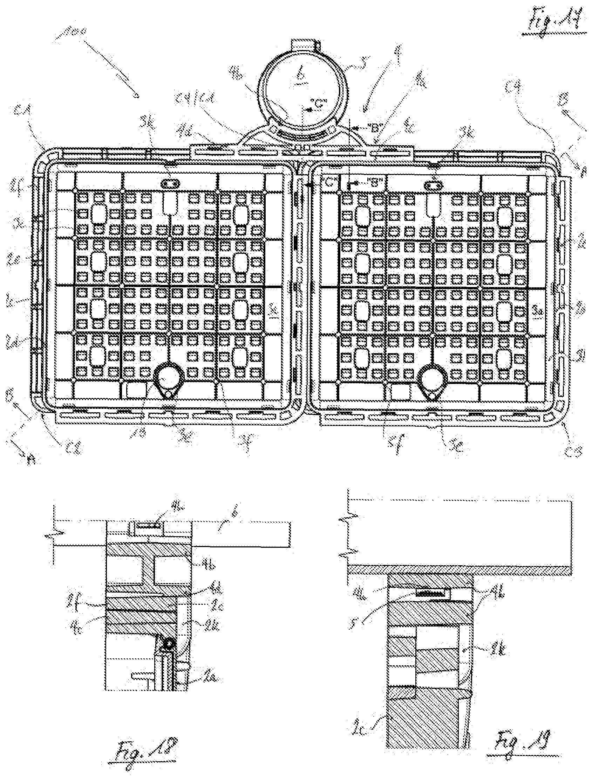

**Figure 17** is a bottom view of the light assembly module system 100 whereby the shown features of light assembly modules 100a and 100b correspond to those shown in Figure 9. A recess 3e through which a motion and ambient sensor assembly can be projected through is shown for each light assembly module 100a and 100b, however in some embodiments it is sufficient that at least one such recess is provided for a light assembly consisting of a plurality of light assembly modules.

**Figure 18** shows cross-section B - B indicated in Figure 17 shows second structure 4b abutting pole 6 and inner wall 4d of first structure 4a abutting face-to-face the outer wall 4c of the fixture rim 2b of light assembly module 100a. Said outer wall 4c of the fixture rim 2b and its projection 2f is wedged in between inner wall 4d of the mount 4 and its outer wall 4c. Strengthening rib 2k extends across the inner and outer walls 2d and 2c of the fixture rim and the outer wall 4c of the mount.

**Figure 19** shows cross-section C - C indicated in Figure 17 cutting across the overlap region C4 / C1 at the object side between the two neighbouring light assembly modules 100a and 100b. Because of the divergence of the outer wall 2c in corner region C1 of light assembly module 100a from the outer wall 4c in corner region C4 of light assembly module 100b, the cross-section shows empty space between outer wall 2c of light assembly module 100a and the second structure 4b of the mount.

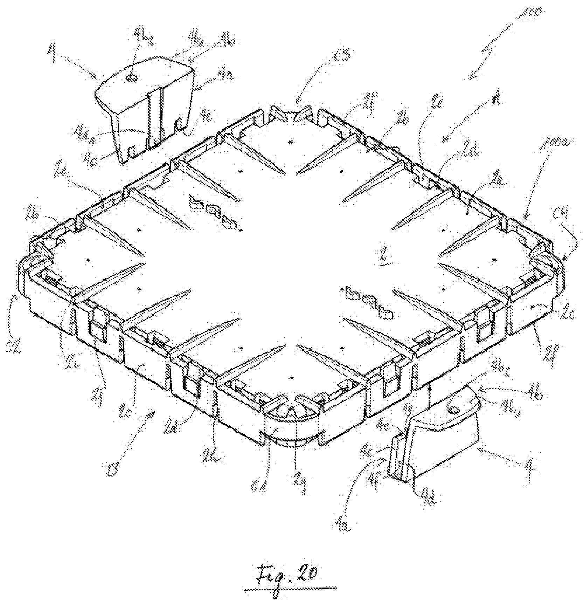

**Figure 20** is a perspective view onto a light assembly module 100a suitable for highbay installation. The light assembly module 100a is a part of a light assembly module system 100 including two bracket mounts 4 with different shapes. The light assembly module 100a itself corresponds to the light assembly module 100a or 100b shown in Figures 3 to 19. The symbols pointing to features of the light assembly module 100a in this figure correspond to those described in reference to the previous figures but some may be shaped slightly differently. For mounting the light assembly module 100a to a highbay or ceiling, the light assembly module system 100a comprises a first bracket mount 4 comprising a clip element including an outer wall 4c facing the light assembly module 100a, the outer wall 4c being demarked from an inner wall 4d by means of recess 4f, wherein the inner wall 4d extends upward toward the highbay or ceiling. Extending away from the clip element, in particular from the upper end of the inner wall 4d, is a flange 4b₁ as part of the second structure 4b for engagement directly with the highbay or ceiling or with an intermediate connector. The flange 4b₁ of the second structure 4b may comprise a recess 4b₂ through which an intermediate connector such as a screw or bolt can be inserted for fixing the light assembly module 100a to the highbay or ceiling. The upper surface of the flange 4b₁ can lie flat against a counterpart surface of the highbay or ceiling. As in the other examples described throughout this document, the outer wall 4c of the first mount 4 comprises at least one projection 4e for insertion into a corresponding recess 2e of the light assembly module's fixture rim 2b, preferably in section A of the latter. Second bracket mount 4 on the other side of the light assembly module 100a is shaped differently from first mount 4 in that its first structure 4b comprises a projection 4e projecting in the opposite direction of projection 4e of first mount, i.e. in the illumination direction of the light assembly module 100a. The projection 4e comprises a clip element 4a₁ which hooks into the side of inner wall 2d of the base plate's fixture rim 2b when the projection 4e is inserted into a corresponding recess 2e in section A of the base plate's fixture rim 2b. Extending away from the projection 4e and the light assembly module 100a, the second mount 4 comprises a second structure 4b in the form of a flange corresponding to the flange, including the recess 4b₂, of the first mount 4. Although bird protectors are not shown because the light assembly module system is intended for use in highbays or on ceilings, if the light assembly module is instead hung with a certain gap to the highbay or ceiling, it may comprise bird protectors as shown in other embodiments of the invention. As can be understood from this embodiment of the light assembly module system 100, the design of the fixture rim 2b allows a number of different mounts to be fixed to it, thereby allowing the light assembly module 100a to be attached to a variety of surfaces. The light assembly module system is preferably used as a highbay or ceiling light.

**Figure 21** shows a light assembly module 100a corresponding to the light assembly module shown in Figure 4 with the exception of cover assembly 3. The cover assembly 3 comprises a base sheet 3a and an optical function sheet 3g in a stacked arrangement. The base sheet 3a comprises a planar outer face facing away from the light sources 10b on the PCB 9. The base sheet 3a comprises a recess 3n through which the port 3k, in particular walled opening 3m of the cover assembly projects. In this embodiment, the walled opening 3m projects from the outer face of the underlying optical function sheet 3g, of which only the edge is shown in this perspective. Additional details of the optical function sheet 3g are shown in the following figures. A gap is provided between the wall opening 3m of the port 3k and the edge of the recess 3n of the base sheet 3a so that the connector opening 7d of the cable assembly termination cover 7e can be inserted into the gap in a sealing insertion fit.

**Figure 22** shows the light assembly module according to Figure 21 viewed from another angle showing, in addition to features shown in previous figures, the connector opening 7d of the cable assembly termination cover 7e facing the port 3k, the inner face of the optical function sheet 3g, the inner face 9d of the electronic circuit carrier 9, the gasket 12 along with the outer surface 2a of the base plate 2. The inner face of the optical function sheet 3g comprises an array of optically refractive areas 3h in the form conical projections whose vertices point in the direction of the light sources 10b (see previous figure) and whose bases merge into the plane of the inner face of the optical function sheet 3g. The optical function sheet 3g is also shown to comprise a fixture rim 3p including two ridges projecting against the direction of illumination which have a common centroid and which run alongside the inner surface (see feature 2t of Figure 4) of the inner wall 2d of the fixture rim 2b of the base plate 2. As explained with reference to Figure 4, said fixture rim 3p clamps over a corresponding ridge 2q formed on the inner face 2a of base plate 2.

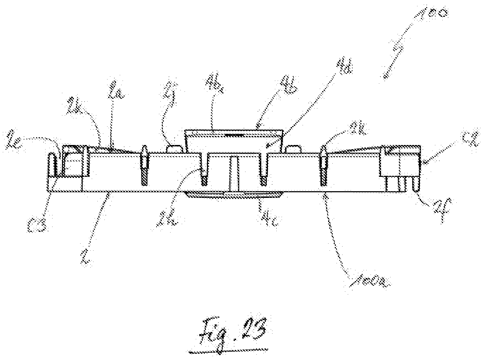

**Figure 23** is front edge-on view of the light assembly module system 100 according to Figure 20 showing the inner face of first mount 4 and the front side of light assembly module 100a between corners C2 and C3. For a view onto the first mount 4, the second mount is not shown. A part of the inner wall 4d of the first mount 4 extending higher than the outer face 2a of the base plate 2 along with the lower edge of the outer wall 4c of the first mount 4 are shown. In particular, the inner wall 4d and the second structure 4b extending therefrom is higher than the outer wall 4c of first mount 4 so that a gap can be maintained between the light assembly module 100a and a ceiling. The illumination direction is downward in this image. The remaining features of the light assembly module 100a shown here correspond to those of preceding figures.

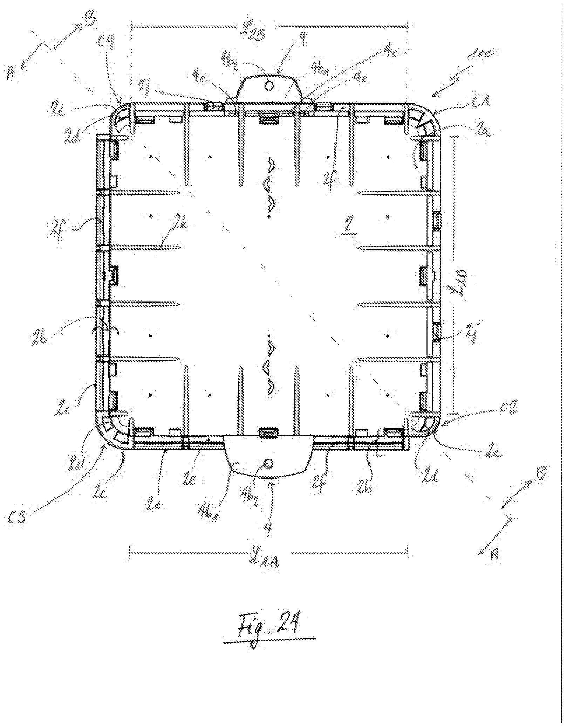

**Figure 24** is a top view onto light assembly module system 100 including light assembly module 100a and first and second mounts 4. The second structures 4b of both mounts are shown to comprise flanges 4b₁ extending away from the base plate 2 with holes 4b₂ through which intermediate connectors such as screws or bolts can be passed for fixing the mounts to an object such as a ceiling of highbay.

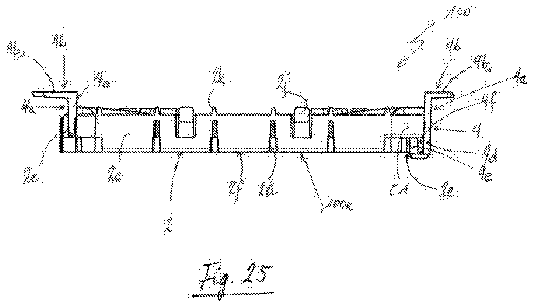

**Figure 25** is a side view of the light assembly module system 100 shown in Figures 20, 23 and 24. In addition to features already described, this perspective provides a view onto the clip element of the first structure 4a of the first mount 4, wherein at the base of the recess 4f, the inner wall 4d transitions into outer wall 4c and its projections 4e. On the other hand, second mount 4 comprises a downwardly oriented projection 4e of its outer wall 4c hooked into recess 2e of fixture rim 2b by means of clip element 4a₁ (see Figure 20).

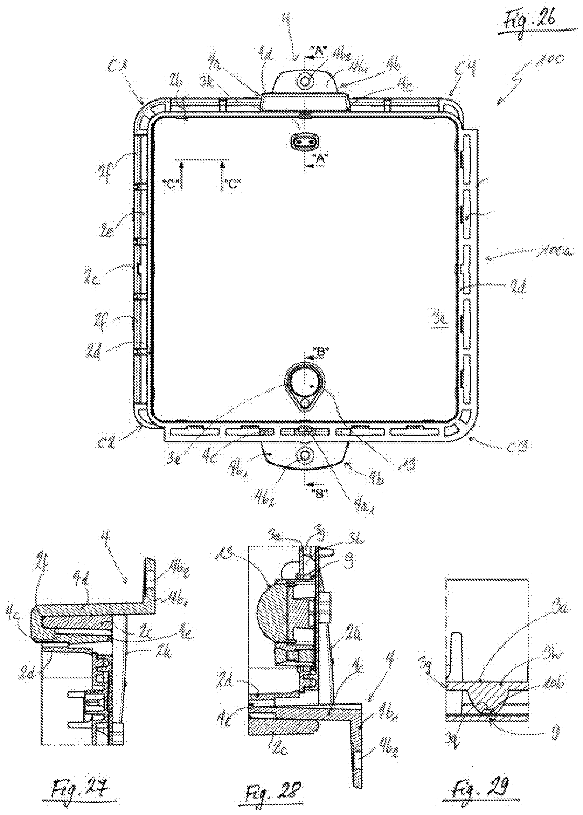

**Figure 26** is view onto the light assembly module system 100 showing the illumination side of base plate 3a. In the first structure 4a of the first mount 4, the transition from the inner wall 4d to the outer wall 4c extends across the outer wall 2c of the base plate's fixture rim 2b. The insertion end of projection 4e in first structure 4a is shown wedged in between the inner and outer walls 2d and 2c of the base plate's fixture rim 2b.

**Figure 27** is a view of cross section A-A indicated in Figure 26 showing how the first structure 4a of first mount 4 wraps around projection 2f of the base plate's outer wall 2c, whereby the insertion end of the projection 2f abuts the base of the recess 2e. The ridges 3p on the inner face of the optical function layer 3g are shown in cross-section (see also Figure 22), whereby ridge 2q on the inner face 2s of base plate 2 (see Figure 4) is inserted into the gap between the two ridges 3p of the optical function layer in a tight fit.

**Figure 28** is a view of cross-section B-B indicated in Figure 26 and in particular shows a cross section of the motion and / or ambient sensor assembly 13 mounted on electronic circuit carrier 9. In addition, conical optically refractive structure 3h is shown extending through optical function sheet 3g, wherein the base of the cone merges into outer surface of said optical function sheet 3g on which base sheet 3a is arranged. Light is emitted from right to left in this image.

**Figure 29** is a view of cross-section C-C indicated in Figure 26 and shows the profile of the conical optically refractive structure, wherein the vertex of said structure comprises a cavity 3q bounded by a rim abutting or nearly abutting the PCB 9. The cavity in the vertex of the conical optically refractive structure 3h surrounds the LED 10b.

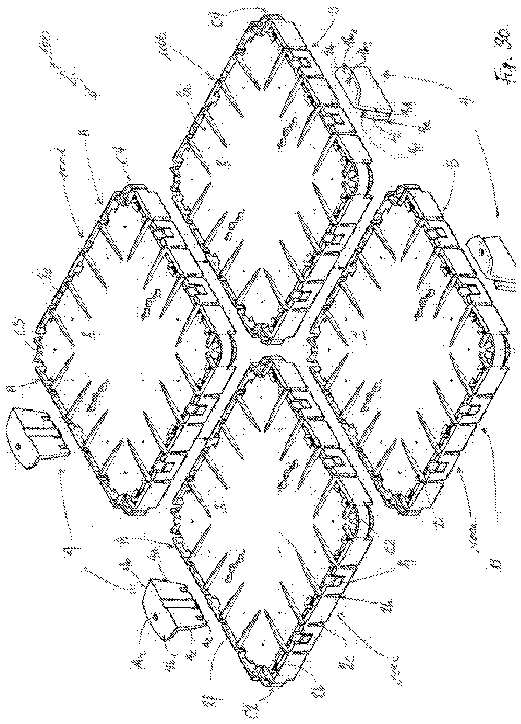

**Figure 30** is a perspective view of a scaled up light assembly module system 100 comprising 4 light assembly modules 100a, 100b, 100c and 100d. First mounts 4 engage fixture rims 2b in sections B of light assembly modules 100a and 100b and second mounts 4 engage fixture rims 2b in sections A of light assembly modules 100c and 100d. Light assembly modules 100c and 100d are hooked into light assembly modules 100a and 100b. In particular, the projections 2f in sections A of the outer walls 2c of their fixture rims 2b are inserted into counterpart recesses 2e of fixture rims 2b in sections B of light assembly modules 100a and 100b. Without modifying the fixture rims 2b, therefore, the light assembly module system 100 can be scaled up using the same mounts as previously described. Features of the individual light assembly modules correspond to those already described.

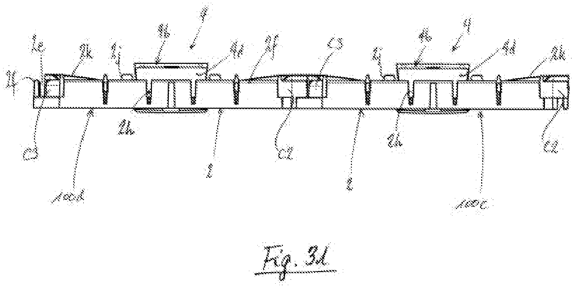

**Figure 31** is a front view of the scaled-up light assembly module system 100 shown in the previous figure and also shows features already described in relation to the light assembly module system shown in Figure 23.

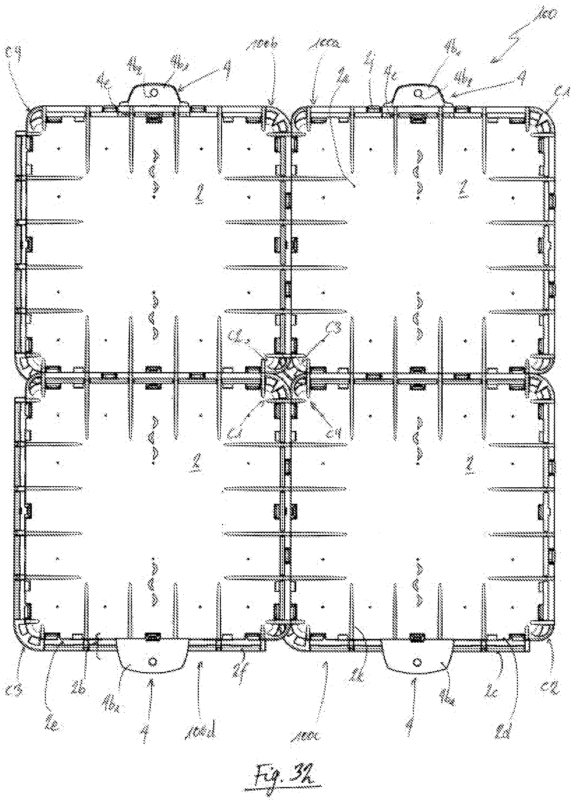

**Figure 32** a top view of the scaled-up light assembly module system 100 shown in Figure 30. Features of the individual light assembly modules and mounts correspond to those already described. Figure 32 additionally provides a view onto the overlap region C1/C2/C3/C4 in the centre of the light assembly module system 100 where corner region C3 of light assembly module 100a, corner region C2 of light assembly module 100b, corner region C1 of light assembly module 100d and corner region C4 of light assembly module 100c overlap for maximum compactness of the light assembly module system.

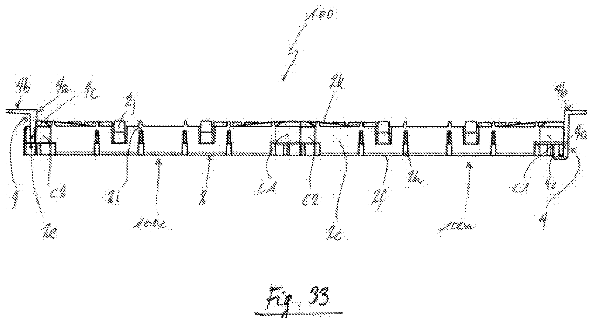

**Figure 33** is a side view of the scaled-up light assembly module system 100 shown in Figure 30 and also shows features already described in relation to the light assembly module system shown in Figure 25.

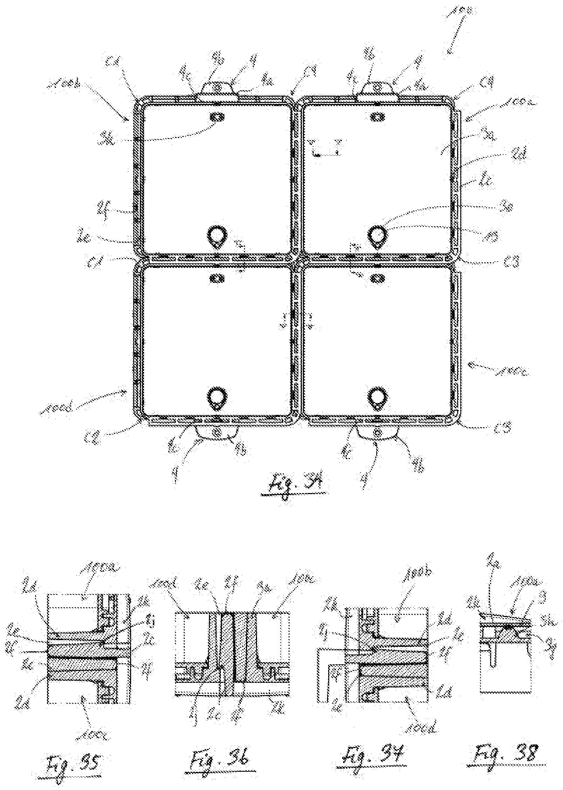

**Figure 34** is a view of the light assembly module system 100 shown in Figure 30 and additionally shows features already described in relation to the light assembly module system shown in Figure 26.

**Figure 35** is a view of cross-section A-A indicated in Figure 33. Projection 2f of outer wall 2c of light assembly module 100c's fixture rim is shown in this figure above projection 2f of outer wall 2c of light assembly module 100a's fixture rim, whereby the projections are inserted into recesses 2e of the respective other light assembly module, the faces of the projections 2f abutting or nearly abutting in a compact side-by-side arrangement of the light assembly modules 100c and 100a.

**Figure 36** is a view of cross-section B-B indicated in Figure 33 and shows the same features of light assembly modules 100c and 100d previously shown. In particular, however, the image shows projection 2f of outer wall 2c of light assembly module 100d's fixture rim at the right of projection 2f of outer wall 2c of light assembly module 100c's fixture rim, the faces of the projections 2f abutting or nearly abutting in a compact side-by-side arrangement of the light assembly modules 100c and 100d.

**Figure 37** is a view of cross-section C-C indicated in Figure 33 and shows the same features of light assembly modules 100c and 100d previously shown. In particular, however, the image shows projection 2f of outer wall 2c of light assembly module 100d's fixture rim above projection 2f of outer wall 2c of light assembly module 100b's fixture rim 2b, the faces of the projections 2f abutting or nearly abutting in a compact side-by-side arrangement of the light assembly modules 100d and 100b.

**Figure 38** is a view of cross-section D-D indicated in Figure 33 showing features corresponding to those shown in Figure 29.

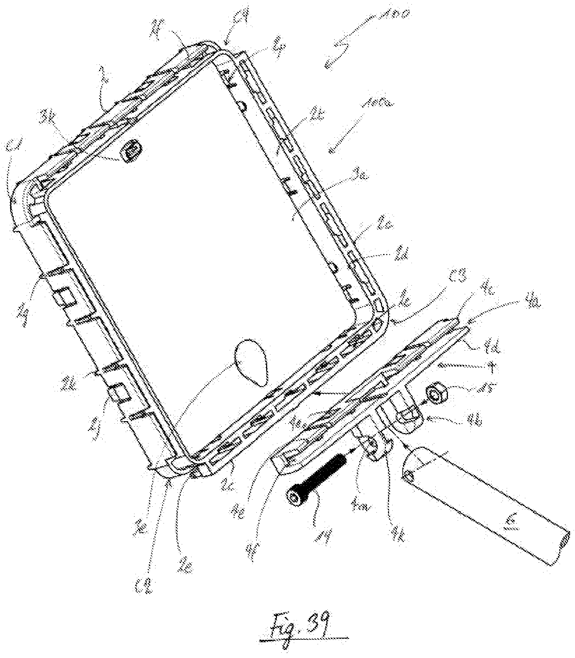

**Figure 39** is a blow-up view of a light assembly module system 100 comprising a light assembly module 100a with features shown in Figure 21 and 22. In addition, the light assembly module system 100 comprises a bracket mount 4 with a first structure 4a corresponding to that shown in Figures 3 and 12, however the light assembly module 100a is flipped compared to the light assembly module shown in these figures, i.e. the mount 4, in particular its projections 4e, engage the recesses 2e from the side of the outer face 2a of base plate 2 instead of from its illumination side. This manner of attaching the light assembly module 100a to the mount 4 is suitable in particular for use of the light assembly module as a floodlight. The second structure 4b of the mount 4 comprises a clamp with a first and second projections 4k projecting outward from the first structure 4a and away from the light assembly module 100a. The projections 4k each comprise a hole 4m for lateral insertion of a screw or bolt 14, for example an Allen bolt, where lateral is intended to mean perpendicular to the direction of illumination. An object 6, for example a pipe or pole, to which the light assembly module system 100 shall be attached is inserted into the clamp between the projections 4k and the bolt 14 is passed through the first projection 4k, the object 6 and the through the second projection 4k or visa versa. The bolt is fastened to the clamp with a nut 15 at one of its ends. The light assembly module system is preferably used as a hoarding or billboard light.

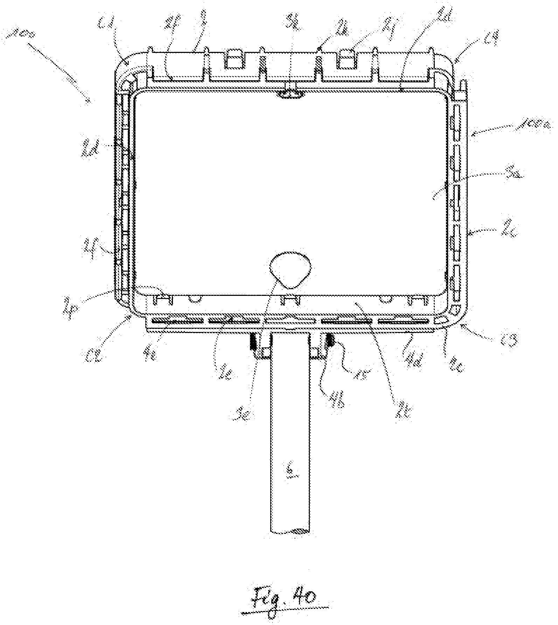

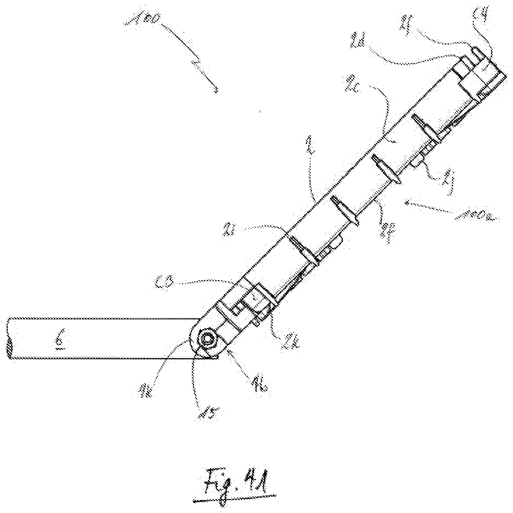

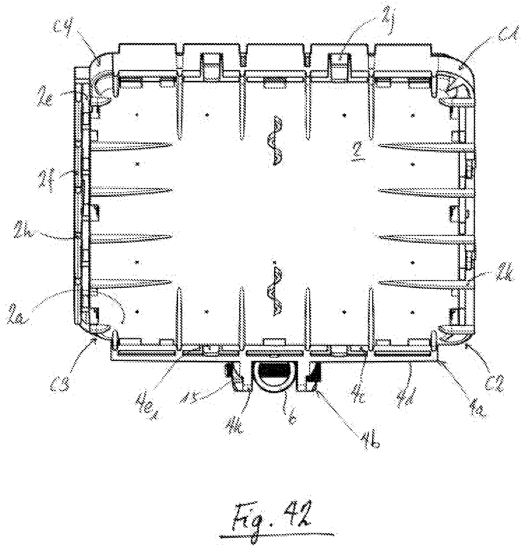

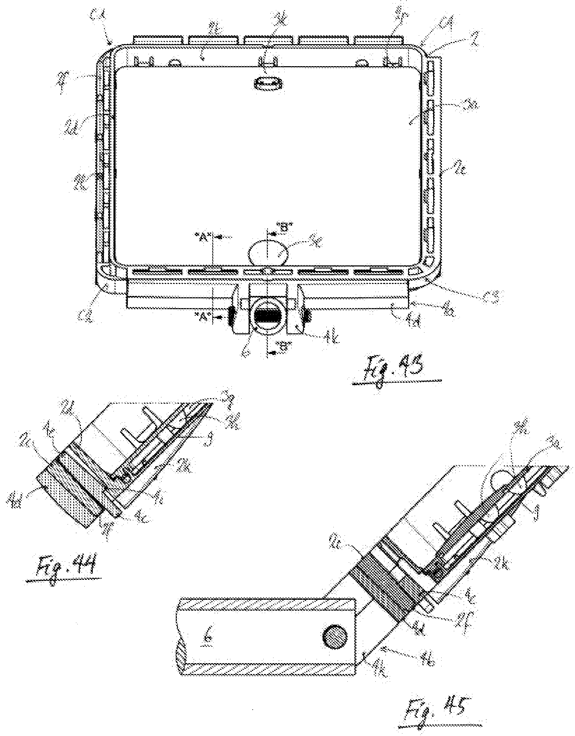

While **Figure 40** is a view onto the illumination side of the light assembly module system 100 shown in Figure 39 with features corresponding to those shown in Figure 39 and Figures 21 and 22, **Figure 41** is a side view and **Figure 42** is a top view onto the light assembly module system 100. **Figure 43** is a view onto the illumination side of the light assembly module system 100 according to Figure 40 but at a steeper angle.

**Figure 44** shows cross-section A-A shown in Figure 43 with features shown in Figures 10 and 11 but in opposite orientation due to the light assembly module being flipped compared to the one shown in Figures 10 and 11.

**Figure 45** shows cross-section B-B cutting through the recess 3j in base sheet 3a and optical function sheet 3g through which an optional motion and / or ambient sensor assembly would project and also through mount 4 and object 6. The remaining features correspond to those previously described.

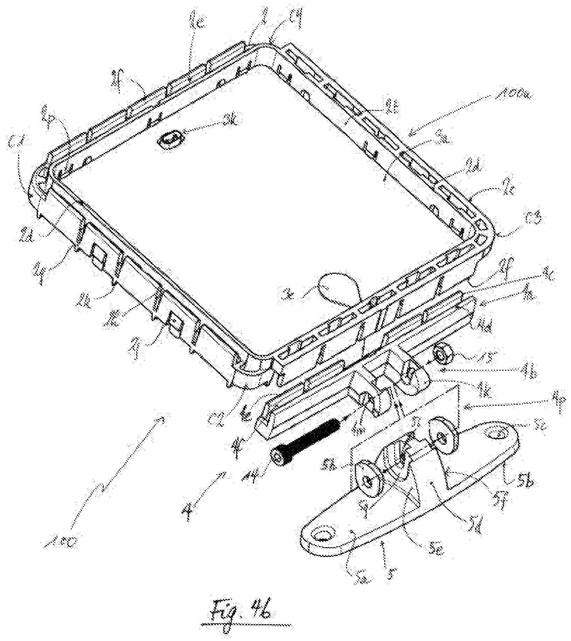

**Figure 46** corresponds to Figure 39 with the difference that the mount 4 is fixed to an intermediate connector 5 connected to it via a pivot joint 4p. The intermediate connector 5 comprises a plate 5a comprising a contact surface 5b for contacting an object 6. Plate 5a comprises holes 5c through which fixing means such as screws or bolts can be inserted for fixing the plate to the object 6. The intermediate connector further comprises a projection 5d serving as a hinge. The projection 5d comprises lateral surfaces 5e and 5f with surface normals in mutually opposing directions but perpendicular to the direction of illumination as explained with reference to Figure 39. The lateral surfaces 5e, 5f are recessed with recesses 5g to accommodate washers 5h. Extending laterally through the projection 5d is a hole 5i opening into the recesses 5g. Outer surfaces of the washers 5h inserted into the recesses 5g are flush with the lateral surfaces 5e, 5f of the projection 5d. The clamp of the second structure 4b comprising projections 4k clamps the projection 5d at the site of the washers 5h such that screw or bolt 14 can be passed through holes 4m of the projections 4k of the second structure 4b of the mount 4, through the washers 5h and through the hole 5i of the projection 5d.

The interaction of the projections 4k of the mount 4 which tiltably engage either side 5e, 5f the projection 5d of the intermediate connector 5 can thus be viewed as constituting a part of the pivot joint, the axis of the pivot joint preferably passing through the centres of holes 4m of mount 4, the washers 5h and the hole 5i of the projection 5d. The longitudinal axis of the bolt or screw 14 passed through said holes is therefore aligned with the axis of the pivot joint. The mount 4 and the light assembly module 100a attached thereto can thus pivot about the axis of the inserted screw or bolt 14. The light assembly module system 100 is preferably used as a floodlight.

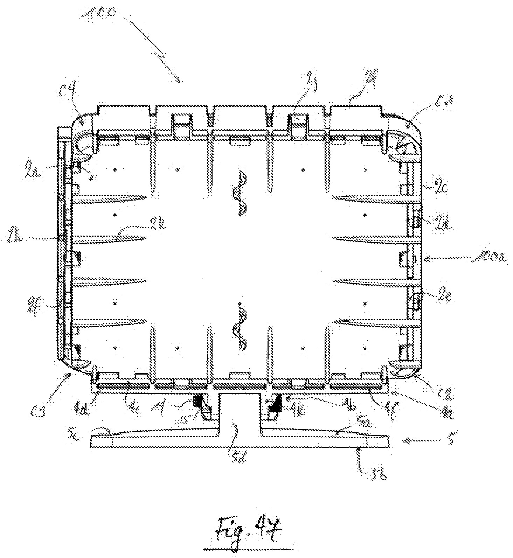

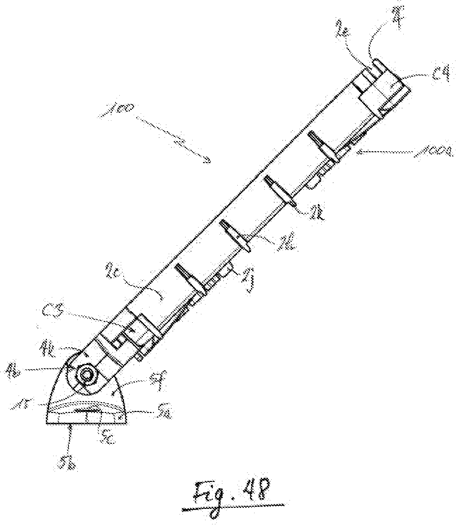

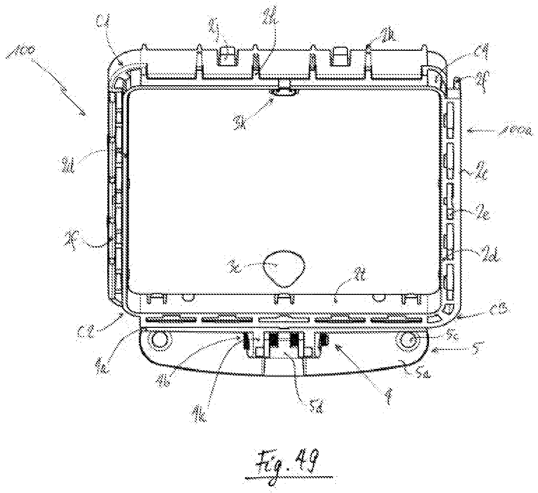

**Figure 47** is a top or bird's eye view, **Figure 48** a side view and **Figure 49** a bottom view (view onto illumination side) onto the light assembly module system 100 shown in **Figure 46****.**

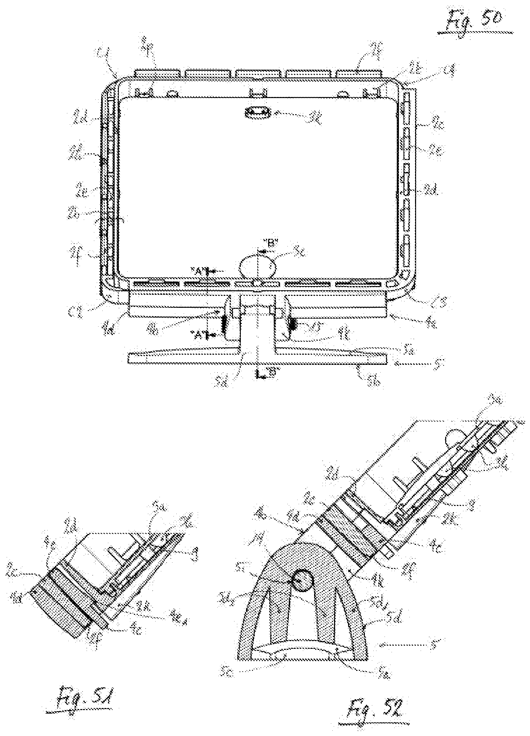

**Figure 50** is essentially the same view of the light assembly module system 100 as Figure but the light assembly module is tilted away from the viewer and the plate 5a of intermediate connector 5 is seen edge-on. Cross-sections A-A and B-B are indicated which are shown in the following figures.

**Figure 51** is a view onto cross-section A-A of the fixture rim 2b of the light assembly module 100a inserted into the clip of the first structure 4a of mount 4. The features of the cross-section correspond to those of Figure 44. Similarly, **Figure 52** is analogous to Figure 45, however the cross-section shows the interior of the projection 5d of the intermediate connector 5 to comprise a parabolic outer shell 5d₁. Extending vertically from the inner surface of the outer shell 5d₁ toward the plate 5a re supporting legs 5d₂. The bolt or screw 14 is inserted through hole 5i of the projection 5d so that it is arranged in the seat of the parabola, i.e. between the inner surface of the outer shell 5d₁ and the legs 5d₂ extending therefrom.

**Figure 53** is an exploded view of a motion and ambient sensor assembly 13 for mounting on the electronic circuit carrier 9, for example for mounting on the PCB 9 as shown here. The motion and ambient sensor assembly 13 comprises an ambient, in particular an ambient light sensor 13b and a motion sensor 13a, the latter preferably including at least one of an optical sensor, microwave sensor, infrared sensor and acoustic sensor. Each sensor is preferably contained in a housing, in the case of the ambient sensor 13b in a cylindrical housing and in the case of the motion sensor 13a, in a larger housing which may accommodate any of the plurality of motion sensor examples indicated above. The ambient and motion sensor assembly 13 preferably also comprises a transmitter for transmitting an illumination signal to a controller (not shown) for controlling the LEDs 10b. The ambient sensor 13b and the motion sensor 13a are preferably arranged on a common carrier 13e shaped as a plate for mounting onto the PCB 9. The ambient and motion sensor assembly 13 further comprises an outer shell 13c accommodating both sensor types with their respective housings. To that end, the outer shell 13c preferably comprises two recesses into which each sensor including its respective housing can be inserted. In addition, a gasket 13d is provided which snugly fits around the base outline of the outer shell 13c, the base outline preferably being defined by a flange. When the cover assembly 3 is placed on the electronic circuit carrier 9 (see, for example, Figure 21), the inner edge of the recess 3j of the cover assembly will come to rest on the gasket 13d of the ambient and motion sensor assembly 13, letting the sensor assembly 13 project through the recess 3j but at the same time sealing off the interior of the light assembly module against the environment, in particular against moisture and dust.

**Figure 54** is a perspective close-up view of the outer face 9c of the electronic circuit carrier 9 showing some of its detailed topology with mounted electronic components. In particular, light sources 10b, here LEDs, are shown bridging a first dielectric clearance gap 9g₁, on either side of which are arranged first electrical conductors 10e of the electronic circuit. The anode of an LED 10b contacts an electrical conductor 10e on one side of the first dielectric clearance gap 9g₁ while the cathode of said LED contacts an electrical conductor 10e on the other side of the first dielectric clearance gap 9g₁. The first dielectric clearance gap 9g₁ preferably extends in a line from one side of the electronic circuit carrier 9g₁ to another side. Preferably, however, the edges of the electronic circuit carrier are kept free of electronic circuitry and components. As shown in the present drawing, a plurality of first dielectric clearance gaps 9g₁ are provided in an array of parallel lines across the outer face 9c of the electronic circuit carrier 9 and pass underneath each LED 10b. A second type of dielectric clearance gap 9g₂ is provided on the outer face of the electronic circuit carrier 9. The second type of dielectric clearance gap 9g₂ is orientated at an angle, preferably at 90°, against the first dielectric clearance gaps 9g₁, The first dielectric clearance gaps 9g₁ preferably comprise an electrically insulating material such as an insulating masking ink, for example a white insulating masking ink. In an embodiment, the electrical conductors 10e of the electronic circuit carrier 9 that contact the LEDs are at least partially covered with an electrically insulating material, such as the insulating masking ink. The area of each electrical conductor 10e contacting the LEDs 10b is bounded by the first and second dielectric clearance gaps 9g₁ and 9g₂, and, if additional components 10f are arranged on the electronic circuit carrier 9, such as filters or surge protectors, by dielectric clearance gaps surrounding these components and surrounding the electrical conductors 10g leading to these components. The sum total of the area of the electrical conductors 10e contacting the LEDs 10b is therefore approximately equal to the area of the outer face 9c of the electronic circuit carrier 9 minus the total area of the dielectric clearance gaps between current-carrying components of the electronic circuit. In this way, the electrically conductive area on the outer face 9c of the electronic circuit carrier 9 is maximized. The electrical conductors 10e contacting the LEDs 10b therefore also function as heat dissipation surfaces. This advantageously eliminates the need for structures dedicated solely to heat dissipation, such as heat sinks. Because the thermal management is optimized by the maximized surface area of the electrical conductors 10e contacting the LEDs 10b, a high density of LEDs per light assembly module can be achieved. When a plurality of light assembly modules are joined together in a multiple light assembly module set and / or system, the heat generated by the combined light sources and by additional circuit components generating heat is dissipated so well that high levels of brightness can be achieved without having to significantly deviate from the optimal operating temperatures of the light sources.

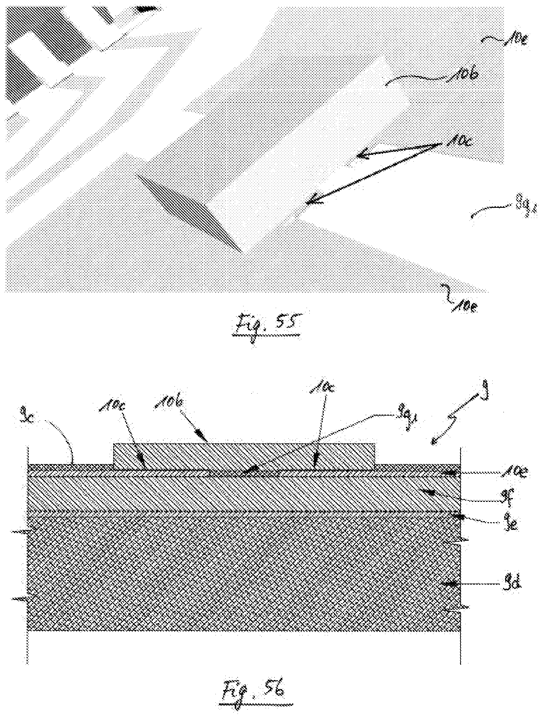

**Figure 55** is a perspective close-up view of an LED 10b shown in the previous figure, the LED 10b bridging the dielectric clearance gap 9g₁ and contacting an electrical conductor 10e on either side via contact pads 10c on the underside of the LED die. Preferably, the electrical conductors 10e comprise tongues that partially extend under the LED 10b, preferably orthogonal to the longitudinal axis of the dielectric clearance gap 9g₁. The tongue portions of the electrical conductors 10e facilitate fully contacting the contact pads 10c of the LED 10b. Underneath the LED 10b, the width of the first dielectric gap 9g₁ is narrowed. Although the present figure shows the electrical conductors 10e to each comprise a tongue portion extending underneath the LED 10b, said tongue portion may not be necessary if the footprint of the LED 10b is large enough to overlap the edge regions of the electrical conductors 10e such that full surface contacting of the LED to the electrical conductors 10e via the contact pads 10c is enabled.

**Figure 56** shows a cross-section of an electronic circuit carrier 9 on which an LED 10b is mounted via contact pads 10c. Preferably, the LED 10b comprises a silicon die chip. An anode LED contact pad 10c is arranged on an electronic conductor10e as shown in the previous drawings and a cathode LED contact pad 10c is arranged on an electronic conductor 10e on the other side of dielectric clearance gap 9g₁ The electronic conductors 10e preferably contain copper and the contact pads 10 preferably at least one element out of the group: nickel, gold, copper, aluminium, tin. Preferably, the contact surfaces of the LED contact pads 10c on the LED die side and on the electrical conductor side have a combined area at least 10% of footprint of the LED die for enhanced heat spread and management, preferably up to 50%. The electrical conductors 10e are arranged on FR4 epoxy layer 9f which in turn is arranged on first copper layer 9e. Copper layer 9e may contact components and conductors on the outer face 9c of the electronic circuit carrier 9 by means of through contacts or via holes (not shown). Copper layer 9e is arranged on a substrate 9d, preferably containing a plastic material.

### LIST OF DESIGNATIONS

- 100a: light assembly module
- 100b to 100d: additional light assembly modules
- C1/C2/C3/C4: corner of light assembly module
- 100: light assembly module system
- 2: base plate of light assembly module
- 2a: outer face of base plate
- 2b: fixture rim
- 2c: outer wall of base plate
- 2d: inner wall of base plate
- 2e: recess in fixture rim between inner and outer wall
- 2f: projection of outer wall of base plate
- 2g: bridge section of outer wall of base plate
- 2h: notch in outer wall of base plate
- 2i: bridge section
- 2j: clip of base plate's outer wall projection
- 2k: strengthening rib of base plate
- 2m: alignment pin on inner face of base plate
- 2p: clip in inner side 2t of base plate's inner wall
- 2q: ridge on inner surface 2s of base plate along inner side 2t
- 2r: projection extending from inner surface 2s of base plate
- 2s: inner surface of base plate on reverse side of base plate's outer
- face: 2a
- 2t: inner side of base plate's inner wall
- 3: cover assembly of light assembly module
- 3a: base sheet of cover assembly
- 3b: recess in base sheet to receive optically refractive structure of optical function layer 3g
- 3c: bead rim of base sheet
- 3d: strengthening rib of base sheet
- 3e: recess in base sheet to receive sensor assembly
- 3f: fixing hole of base sheet
- 3g: optical function sheet
- 3h: optically refractive structure of optical function sheet
- 3i: clip on optically refractive structure
- 3k: port in base sheet for connecting electronic circuit
- 3m: walled port opening
- 3n: recess in base sheet to receive walled port opening 3m and
- cable: assembly connector
- 3p: ridge on inner face of optical function sheet 3g
- 3q: recess in vertex of optically refractive structure 3h
- 4: Mount
- 4a: first structure of mount
- 4b: second structure of mount
- 4b₁: flange section in second structure of mount
- 4b₂: fixing hole in second structure of mount
- 4c: outer wall of mount on light assembly module side
- 4d: inner wall of mount on object side
- 4e: projection of mount's outer wall
- 4e₁: clip of mount's outer wall projection
- 4f: recess of mount between inner and outer walls
- 4g: notch in outer wall of mount
- 4h: recess in second structure for receiving intermediate connector
- 4i: seat in projection 4e of mount's outer wall
- 4j: interruption in outer wall of mount
- 4k: clamping projections of mount's second structure
- 4m: hole in clamping projections of mount's second structure
- 4p: movable joint
- 5: intermediate connector
- 5a: plate of intermediate connector
- 5b: contact surface of intermediate connector's plate
- 5c: fixing hole in intermediate connector
- 5d: projection serving as hinge of intermediate connector
- 5d₁: outer shell of projection 5d
- 5d₂: support legs of outer shell 5d₁
- 5e: first lateral surface of projection 5d
- 5f: second lateral surface of projection 5d
- 5g: recess in lateral surface 5e or 5f
- 5h: washer
- 5i: hole in projection 5d
- 6: object
- 7: cable assembly
- 7a: first insulated cable of cable assembly
- 7b: second insulated cable of cable assembly
- 7c: cable input opening of cable assembly termination cover 7e
- 7d: connector opening of cable assembly termination cover 7e
- 7e: cable assembly termination cover
- 8: contact pins
- 9: electronic circuit carrier
- 9a: fixing hole in electronic circuit carrier
- 9b: dielectric through-hole in electronic circuit carrier
- 9c: outer face of electronic circuit carrier
- 9d: substrate of electronic circuit carrier
- 9e: inner electrically conductive layer of electronic circuit carrier
- 9f: dielectric layer of electronic circuit carrier
- 9g₁: first dielectric clearance gap of electronic circuit carrier
- 9g₂: second dielectric clearance gap of electronic circuit carrier
- 10: electronic circuit
- 10a: i/o terminal of electronic circuit
- 10b: light source
- 10c: electrical contact pad
- 10e: conductor of electronic circuit
- 10f: additional electronic component of electronic circuit
- 11: Bluetooth module
- 12: gasket along inner side 2t of base plate's inner wall
- 13: sensor assembly
- 13a: motion sensor
- 13b: ambient sensor
- 13c: outer shell of ambient and motion sensor assembly
- 13d: gasket for outer shell 13c
- 13e: base plate of ambient and motion sensor assembly
- 14: bolt or screw
- 15: nut for bolt or screw
- 16: bird protector

## Claims

1. A light assembly module (100a) including a plurality of light sources (10b), the light assembly module comprising a base plate (2) with a fixture rim (2b) shaped for mechanical engagement with another light assembly module (100b, 100c, 100d), the fixture rim (2b) comprising an outer wall (2c) and an inner wall (2d), wherein the fixture rim (2b) comprises a plurality of projections (2f) and recesses (2e), wherein the projections (2f) constitute a part of the outer wall (2c) and the recesses (2e) are located between the outer wall (2c) and the inner wall (2d), wherein in a first section (A) of the fixture rim (2b), at least one projection (2f) projects away from the light emission direction of the light sources (10b) and in a second section (B) of the fixture rim (2b), at least one projection (2f) projects in the emission direction of the light sources (10b), **characterized in that** the outer wall (2c) comprises notches (2h) which separate a series of the projections (2f) from one another, forming a line of teeth

2. Light assembly module (100a) according to claim 1, wherein the projections (2f) are shaped so as to mechanically engage with recesses (2e) of another light assembly module (100b, 100c, 100d) and / or mount (4).

3. Light assembly module (100a) according to claim 1 or 2, wherein the recesses (2e) are shaped so as to mechanically engage with projections (1f) of another light assembly module (100b, 100c, 100d) and / or mount (4).

4. Light assembly module (100a) according to one of the preceding claims, wherein, relative to the lateral extent of the base plate (2), the shape of the fixture rim (2b) in the first section (A) is inverted with respect to the shape of the fixture rim (2b) in the second section (B).

5. Light assembly module (100a) according to one of the preceding claims, wherein the first section (A) of the fixture rim (2b) extends along half of the outline of the base plate (2) and the second section (B) of the fixture rim (2b) extends along the other half of the outline of the base plate (2).

6. Light assembly module according to one of the preceding claims, wherein an electronic circuit carrier (9) is arranged on the base plate (2), wherein a part of an electronic circuit (10) is arranged on the electronic circuit carrier (9), and wherein the light sources (10b) constitute components of the electronic circuit (10).

7. Light assembly module according to claim 6, wherein the light sources (10b) include LEDs.

8. Light assembly module according to one of the preceding claims, comprising a cover assembly (3) partially permeable to light that covers the light sources (10b) and at least a part of the base plate (2).

9. Light assembly module according to claim 8, wherein the cover assembly (3) comprises a base sheet (3a) and an optical function sheet (3g) in a stacked arrangement, wherein the optical function sheet (3g) is at least partially permeable to light and comprises a plurality of optically refractive structures (3h) for directing and focusing the light emitted from the light sources (10b).

10. Light assembly module according to one of the preceding claims, comprising a sensor assembly (13) with at least one sensor (13b) adapted to sense ambient changes in the vicinity of the light assembly module.

11. Multiple light assembly module set comprising a plurality of light assembly modules (100a, 100b, 100c, 100d) according to one of the preceding claims, wherein the fixture rim (2b) of each light assembly module (100a, 100b, 100c, 100d) engages with the fixture rim (2b) of the at least one other light assembly module (100a, 100b, 100c, 100d) of the set.

12. Light assembly module system (100) including at least one light assembly module (100a, 100b, 100c, 100d) according to one of the preceding claims, the light assembly module system (100) further including at least one mount (4) for mounting the at least one light assembly module (100a, 100b, 100c, 100d) to an object (6), wherein the at least one mount (4) comprises a first structure (4a) shaped to mechanically engage the fixture rim (2b) of the at least one light assembly module (100a, 100b, 100c, 100d) and a second structure (4b) for fixing the mount (4) to the object (6).

13. Light assembly module system according claim 12, wherein the first structure (4a) of the at least one mount (4) comprises a clip element including an inner wall (4d) and outer wall (4c) separated by at least one recess (4f), the clip element being shaped so as to engage the fixture rim (2b) of the at least one light assembly module (100a, 100b, 100c, 100d).

14. Light assembly module system according to claim 12 or 13, wherein the first structure (4a) of the at least one mount (4) comprises at least one projection (4e) shaped so as to mechanically engage with a recess (2e) of the at least one light assembly module (100a, 100b, 100c, 100d).

15. Light assembly module system according to claim 14, wherein the first structure (4a) of the at least one mount (4) comprises a plurality of projections (4e) shaped so as to mechanically engage with recesses (2e) of a plurality of light assembly modules (100a, 100b, 100c, 100d) jointly.

16. Light assembly module system according to one of claims 12 to 15, comprising at least one intermediate connector (5) for connecting the second structure (4b) of the at least one mount (4) to the object.

17. Light assembly module system according to claim 16, comprising a movable joint (4p) for moveably connecting the intermediate connector (5) to the second structure (4b) of the at least one mount (4), the moveable joint (4p) enabling a pivoting or tilting of the mount (4) and the at least one light assembly module (100a, 100b, 100c, 100d) attached thereto with respect to the object (6).

18. Light assembly module system according to claim 16 or 17, wherein the intermediate connector (5) is an element or its functional equivalent chosen out of the group: clamp, plate, tie, fastener comprising a surface resistive against removal of the mount (4) from the object.

## Patentansprüche

1. Beleuchtungsmodul (100a) mit einer Vielzahl von Lichtquellen (10b), wobei das Beleuchtungsmodul eine Grundplatte (2) mit einem Befestigungsrand (2b) umfasst, der zum mechanischen Eingriff mit einem anderen Beleuchtungsmodul (100b, 100c, 100d) geformt ist, wobei der Befestigungsrand (2b) eine Außenwand (2c) und eine Innenwand (2d) umfasst, wobei der Befestigungsrand (2b) eine Vielzahl von Vorsprüngen (2f) und Aussparungen (2e) aufweist, wobei die Vorsprünge (2f) einen Teil der Außenwand (2c) bilden und die Aussparungen (2e) zwischen der Außenwand (2c) und der Innenwand (2d) angeordnet sind, wobei in einem ersten Abschnitt (A) des Leuchtenrandes (2b) mindestens ein Vorsprung (2f) von der Lichtabstrahlrichtung der Lichtquellen (10b) weg und in einem zweiten Abschnitt (B) des Leuchtenrandes (2b) mindestens ein Vorsprung (2f) in die Abstrahlrichtung der Lichtquellen (10b) hineinragt, **dadurch gekennzeichnet, dass** die Außenwand (2c) Kerben (2h) aufweist, die eine Abfolge der Vorsprünge (2f) unter Bildung einer Zahnreihe voneinander trennen.

2. Beleuchtungsmodul (100a) nach Anspruch 1, wobei die Vorsprünge (2f) so geformt sind, dass sie in Aussparungen (2e) eines anderen Beleuchtungsmoduls (100b, 100c, 100d) und/oder einer Halterung (4) mechanisch eingreifen.

3. Beleuchtungsmodul (100a) nach Anspruch 1 oder 2, wobei die Aussparungen (2e) so geformt sind, dass sie mit Vorsprüngen (1f) eines anderen Beleuchtungsmoduls (100b, 100c, 100d) und/oder einer Halterung (4) mechanisch in Eingriff kommen.

4. Beleuchtungsmodul (100a) nach einem der vorhergehenden Ansprüche, wobei die Form des Leuchtenrandes (2b) im ersten Abschnitt (A) bezogen auf die seitliche Erstreckung der Grundplatte (2) gegenüber der Form des Leuchtenrandes (2b) im zweiten Abschnitt (B) invertiert ist.

5. Beleuchtungsmodul (100a) nach einem der vorhergehenden Ansprüche, wobei sich der erste Abschnitt (A) des Beleuchtungsrandes (2b) entlang der Hälfte des Umrisses der Grundplatte (2) und der zweite Abschnitt (B) des Beleuchtungsrandes (2b) entlang der anderen Hälfte des Umrisses der Grundplatte (2) erstreckt.

6. Beleuchtungsmodul nach einem der vorhergehenden Ansprüche, wobei auf der Grundplatte (2) ein elektronischer Schaltungsträger (9) angeordnet ist, wobei auf dem elektronischen Schaltungsträger (9) ein Teil einer elektronischen Schaltung (10) angeordnet ist, und wobei die Lichtquellen (10b) Bestandteile der elektronischen Schaltung (10) sind.

7. Beleuchtungsmodul nach Anspruch 6, wobei die Lichtquellen (10b) LEDs umfassen.

8. Beleuchtungsmodul nach einem der vorhergehenden Ansprüche, umfassend eine teilweise lichtdurchlässige Abdeckanordnung (3), die die Lichtquellen (10b) und zumindest einen Teil der Grundplatte (2) abdeckt.

9. Beleuchtungsmodul nach Anspruch 8, wobei die Abdeckbaugruppe (3) eine Basisfolie (3a) und eine optische Funktionsfolie (3g) in einer gestapelten Anordnung umfasst, wobei die optische Funktionsfolie (3g) zumindest teilweise lichtdurchlässig ist und eine Vielzahl von optisch brechenden Strukturen (3h) zum Lenken und Fokussieren des von den Lichtquellen (10b) emittierten Lichts umfasst.

10. Beleuchtungsmodul nach einem der vorhergehenden Ansprüche, umfassend eine Sensoranordnung (13) mit mindestens einem Sensor (13b), der geeignet ist, Umgebungsveränderungen in der Umgebung des Beleuchtungsmoduls zu erfassen.

11. Mehrfach-Beleuchtungsmodulsatz mit einer Mehrzahl von Beleuchtungsmodulen (100a, 100b, 100c, 100d) nach einem der vorhergehenden Ansprüche, wobei der Befestigungsrand (2b) jedes Beleuchtungsmoduls (100a, 100b, 100c, 100d) mit dem Befestigungsrand (2b) des mindestens einen anderen Beleuchtungsmoduls (100a, 100b, 100c, 100d) des Satzes in Eingriff steht.

12. Beleuchtungsmodulsystem (100) mit mindestens einem Beleuchtungsmodul (100a, 100b, 100c, 100d) nach einem der vorhergehenden Ansprüche, wobei das Beleuchtungsmodulsystem (100) ferner mindestens eine Halterung (4) zum Befestigen des mindestens einen Beleuchtungsmoduls (100a, 100b, 100c, 100d) an einem Objekt (6), wobei die mindestens eine Halterung (4) eine erste Struktur (4a), die so geformt ist, dass sie mechanisch in den Befestigungsrand (2b) des mindestens einen Lichtmontagemoduls (100a, 100b, 100c, 100d) eingreift, und eine zweite Struktur (4b) zum Befestigen der Halterung (4) an dem Objekt (6) umfasst.

13. Beleuchtungsmodulsystem nach Anspruch 12, wobei die erste Struktur (4a) der mindestens einen Halterung (4) ein Clipelement umfasst, das eine Innenwand (4d) und eine Außenwand (4c) umfasst, die durch mindestens eine Aussparung (4f) getrennt sind, wobei das Clipelement so geformt ist, dass es mit dem Befestigungsrand (2b) des mindestens einen Beleuchtungsmoduls (100a, 100b, 100c, 100d) in Eingriff kommt.

14. Beleuchtungsmodulsystem nach Anspruch 12 oder 13, wobei die erste Struktur (4a) der mindestens einen Halterung (4) mindestens einen Vorsprung (4e) aufweist, der so geformt ist, dass er mechanisch in eine Ausnehmung (2e) des mindestens einen Beleuchtungsmoduls (100a, 100b, 100c, 100d) eingreift.

15. Beleuchtungsmodulsystem nach Anspruch 14, wobei die erste Struktur (4a) der mindestens einen Halterung (4) eine Vielzahl von Vorsprüngen (4e) umfasst, die so geformt sind, dass sie mechanisch in Aussparungen (2e) einer Vielzahl von Beleuchtungsmodulen (100a, 100b, 100c, 100d) gemeinsam eingreifen.

16. Beleuchtungsmodulsystem nach einem der Ansprüche 12 bis 15, mit mindestens einem Zwischenverbinder (5) zur Verbindung der zweiten Struktur (4b) der mindestens einen Halterung (4) mit dem Objekt.

17. Beleuchtungsmodulsystem nach Anspruch 16, umfassend ein bewegliches Gelenk (4p) zum beweglichen Verbinden des Zwischenverbinders (5) mit der zweiten Struktur (4b) der mindestens einen Halterung (4), wobei das bewegliche Gelenk (4p) ein Schwenken oder Kippen der Halterung (4) und des daran befestigten mindestens einen Lichtmoduls (100a, 100b, 100c, 100d) in Bezug auf das Objekt (6) ermöglicht.

18. Beleuchtungsmodulsystem nach Anspruch 16 oder 17, wobei das Zwischenverbindungselement (5) ein Element oder sein funktionelles Äquivalent ist, das aus der Gruppe Klemme, Platte, Binder, Befestigungselement ausgewählt wird, das eine Oberfläche aufweist, die dem Entfernen der Halterung (4) vom Objekt widersteht.

## Revendications

1. Module d'ensemble de lumière (100a) comprenant une pluralité de sources de lumière (10b), le module d'ensemble de lumière comprenant une plaque de base (2) avec un rebord de fixation (2b) formé pour la mise en prise mécanique avec un autre module d'ensemble de lumière (100b, 100c, 100d), le rebord de fixation (2b) comprenant une paroi externe (2c) et une paroi interne (2d), dans lequel le rebord de fixation (2b) comprend une pluralité de saillies (2f) et d'évidements (2e), dans lequel les saillies (2f) constituent une partie de la paroi externe (2c) et les évidements (2e) sont situés entre la paroi externe (2c) et la paroi interne (2d), dans lequel dans une première section (A) du rebord de fixation (2b), au moins une saillie (2f) fait saillie à l'opposé de la direction d'émission de lumière des sources de lumière (10b), et dans une seconde section (B) du rebord de fixation (2b), au moins une saillie (2f) fait saillie dans la direction d'émission des sources de lumière (10b), **caractérisé en ce que** la paroi externe (2c) comprend des encoches (2h) qui séparent une série de saillies (2f) les unes des autres, formant une ligne de dents.

2. Module d'ensemble de lumière (100a) selon la revendication 1, dans lequel les saillies (2f) sont formées pour se mettre mécaniquement en prise avec les évidements (2e) d'un autre module d'ensemble de lumière (100b, 100c, 100d) et/ou de support (4).

3. Module d'ensemble de lumière (100a) selon la revendication 1 ou 2, dans lequel les évidements (2e) sont formés pour se mettre en prise, mécaniquement, avec les saillies (1f) d'un autre module d'ensemble de lumière (100b, 100c, 100d) et/ou support (4).

4. Module d'ensemble de lumière (100a) selon l'une des revendications précédentes, dans lequel, par rapport à l'étendue latérale de la plaque de base (2), la forme du rebord de fixation (2b) dans la première section (A) est inversée par rapport à la forme du rebord de fixation (2b) dans la seconde section (B).

5. Module d'ensemble de lumière (100a) selon l'une des revendications précédentes, dans lequel la première section (A) du rebord de fixation (2b) s'étend le long de la moitié du contour de la plaque de base (2) et la seconde section (B) du rebord de fixation (2b) s'étend le long de l'autre moitié du contour de la plaque de base (2).

6. Module d'ensemble de lumière selon l'une des revendications précédentes, dans lequel un support de circuit électronique (9) est agencé sur la plaque de base (2), dans lequel une partie d'un circuit électronique (10) est agencée sur le support de circuit électronique (9), et dans lequel les sources de lumière (10b) constituent des composants du circuit électronique (10).

7. Module d'ensemble de lumière selon la revendication 6, dans lequel les sources de lumière (10b) comprennent des diodes électroluminescentes.

8. Module d'ensemble de lumière selon l'une des revendications précédentes, comprenant un ensemble de couvercle (3) partiellement perméable à la lumière qui recouvre les sources de lumière (10b) et au moins une partie de la plaque de base (2).

9. Module d'ensemble de lumière selon la revendication 8, dans lequel l'ensemble de couvercle (3) comprend une feuille de base (3a) et une feuille de fonction optique (3g) dans un agencement empilé, dans lequel la feuille de fonction optique (3g) est au moins partiellement perméable à la lumière et comprend une pluralité de structures optiquement réfractives (3h) pour diriger et concentrer la lumière émise par les sources de lumière (10b).

10. Module d'ensemble de lumière selon l'une des revendications précédentes, comprenant un ensemble de capteur (13) avec au moins un capteur (13b) adapté pour détecter les changements ambiants à proximité du module d'ensemble de lumière.

11. Jeu de plusieurs modules d'ensemble de lumière comprenant une pluralité de modules d'ensemble de lumière (100a, 100b, 100c, 100d) selon l'une des revendications précédentes, dans lequel le rebord de fixation (2b) de chaque module d'ensemble de lumière (100a, 100b, 100c, 100d) se met en prise avec le rebord de fixation (2b) d'au moins un autre module d'ensemble de lumière (100a, 100b, 100c, 100d) du jeu.

12. Système de module d'ensemble de lumière (100) comprenant au moins un module d'ensemble de lumière (100a, 100b, 100c, 100d) selon l'une des revendications précédentes, le système de module d'ensemble de lumière (100) comprenant en outre au moins un support (4) pour monter le au moins un module d'ensemble de lumière (100a, 100b, 100c, 100d) sur un objet (6), dans lequel le au moins un support (4) comprend une première structure (4a) formée pour mettre mécaniquement en prise le rebord de fixation (2b) du au moins un module d'ensemble de lumière (100a, 100b, 100c, 100d) et une seconde structure (4b) pour fixer le support (4) sur l'objet (6).

13. Système de module d'ensemble de lumière selon la revendication 12, dans lequel la première structure (4a) du au moins un support (4) comprend un élément d'attache comprenant une paroi interne (4d) et une paroi externe (4c) séparées par au moins un évidement (4f), l'élément d'attache étant formé afin de mettre en prise le rebord de fixation (2b) du au moins un module d'ensemble de lumière (100a, 100b, 100c, 100d).

14. Système de module d'ensemble de lumière selon la revendication 12 ou 13, dans lequel la première structure (4a) du au moins un support (4) comprend au moins une saillie (4e) formée afin de se mettre mécaniquement en prise avec un évidement (2e) du au moins un module d'ensemble de lumière (100a, 100b, 100c, 100d).

15. Système de module d'ensemble de lumière selon la revendication 14, dans lequel la première structure (4a) du au moins un support (4) comprend une pluralité de saillies (4e) formées afin de se mettre mécaniquement en prise avec les évidements (2e) d'une pluralité de modules d'ensemble de lumière (100a, 100b, 100c, 100d) conjointement.

16. Système de module d'ensemble de lumière selon l'une des revendications 12 à 15, comprenant au moins un connecteur intermédiaire (5) pour connecter la seconde structure (4b) du au moins un support (4) à l'objet.

17. Système de module d'ensemble de lumière selon la revendication 16, comprenant un joint mobile (4p) pour raccorder, de manière mobile, le connecteur intermédiaire (5) à la seconde structure (4b) du au moins un support (4), le joint mobile (4p) permettant un pivotement ou une inclinaison du support (4) et du au moins un module d'ensemble de lumière (100a, 100b, 100c, 100d) fixé à ce dernier par rapport à l'objet (6).

18. Système de module d'ensemble de lumière selon la revendication 16 ou 17, dans lequel le connecteur intermédiaire (5) est un élément ou son équivalent fonctionnel choisi parmi le groupe comprenant : une pince, une plaque, une attache, une fixation comprenant une surface résistante contre le retrait du support (4) de l'objet.
